(19) Europäisches Patentamt / European Patent Office / Office européen des brevets

(11) **EP 3 478 794 B1**

(12) **FASCICULE DE BREVET EUROPEEN**

(45) Date de publication et mention de la délivrance du brevet:
**10.05.2023   Bulletin 2023/19**

(21) Numéro de dépôt: **17745411.3**

(22) Date de dépôt: **30.06.2017**

(51) Classification Internationale des Brevets (IPC):
**C09K 11/77** (2006.01)   **B82Y 40/00** (2011.01)
**C09K 11/08** (2006.01)   **C09K 11/02** (2006.01)

(52) Classification Coopérative des Brevets (CPC):
**C09K 11/7774; B82Y 40/00; C09K 11/025;**
**C09K 11/08; C09K 11/617; C09K 11/77747;**
C01P 2004/64; Y02B 20/00

(86) Numéro de dépôt international:
**PCT/FR2017/051773**

(87) Numéro de publication internationale:
**WO 2018/002556 (04.01.2018 Gazette 2018/01)**

(54) **PROCEDE DE FABRICATION DE PARTICULES PHOTOLUMINESCENTES**

VERFAHREN ZUR HERSTELLUNG VON PHOTOLUMINESZENTEN PARTIKELN

METHOD FOR PRODUCING PHOTOLUMINESCENT PARTICLES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **30.06.2016   FR 1656171**

(43) Date de publication de la demande:
**08.05.2019   Bulletin 2019/19**

(73) Titulaires:
 • **Aledia**
   **38130 Echirolles (FR)**
 • **Universite Clermont Auvergne**
   **63000 Clermont Ferrand (FR)**
 • **Centre National de la Recherche Scientifique**
   **75794 Paris Cedex 16 (FR)**
 • **Sigma-Clermont**
   **63178 Aubiere Cedex (FR)**

(72) Inventeurs:
 • **ABOULAICH, Abdelhay**
   **38000 GRENOBLE (FR)**
 • **CHADEYRON, Geneviève**
   **63118 Cebazat (FR)**
 • **MAHIOU, Rachid**
   **63100 Clermont-Ferrand (FR)**

(74) Mandataire: **Cabinet Beaumont**
   **4, Place Robert Schuman**
   **B.P. 1529**
   **38025 Grenoble Cedex 1 (FR)**

(56) Documents cités:
   **US-A1- 2013 221 279     US-B2- 8 801 968**

 • **Motoyuki Iijima ET AL: "Surface Modification for Improving the Stability of Nanoparticles in Liquid Media", KONA Powder and Particle Journal, 1 janvier 2009 (2009-01-01), XP055362932, Extrait de l'Internet: URL:https://www.jstage.jst.go.jp/article/k ona/27/0/27_2009012/_pdf [extrait le 2017-04-07]**
 • **YUNG-TANG NIEN ET AL: "Improved Photoluminescence of Y 3 Al 5 O 12 :Ce Nanoparticles by Silica Coating", JOURNAL OF THE AMERICAN CERAMIC SOCIETY., 1 février 2010 (2010-02-01), XP055363107, US ISSN: 0002-7820, DOI: 10.1111/j.1551-2916.2010.03624.x**

**Description**

La présente demande de brevet revendique la priorité de la demande de brevet français FR16/56171.

Domaine

La présente demande concerne les procédés de fabrication de particules d'un matériau photoluminescent.

Exposé de l'art antérieur

Un matériau photoluminescent, également appelé luminophore, est adapté, lorsqu'il est excité par de la lumière à une première longueur d'onde, à émettre de la lumière à une deuxième longueur d'onde différente de la première longueur d'onde. Les matériaux photoluminescents sont utilisés notamment pour la préparation de revêtements fluorescents, en particulier pour la fabrication d'écrans d'affichage, de projecteurs, en particulier des écrans à plasma, des lampes pour le rétroéclairage des écrans à cristaux liquides, des diodes électroluminescentes, des lampes d'éclairage à excitation plasma, des lampes trichromatiques, etc.

Un exemple de matériau photoluminescent est le grenat d'yttrium et d'aluminium activé par l'ion cérium trivalent ($Y_3Al_5O_{12}$:$Ce^{3+}$), également appelé YAG (sigle anglais pour Yttrium Aluminium Garnet) YAG:Ce ou YAG:$Ce^{3+}$. Ce matériau photoluminescent est notamment utilisé pour générer de la lumière blanche après association avec une diode électroluminescente (DEL) bleue. Pour ce faire, la DEL bleue est recouverte d'un revêtement contenant des particules de YAG:$Ce^{3+}$. Une partie de la lumière bleue est convertie en lumière jaune par le revêtement photoluminescent, ce qui permet d'obtenir la lumière blanche.

Les matériaux photoluminescents peuvent être fabriqués par des réactions à l'état solide. Par exemple, dans le cas du YAG:Ce, des précurseurs solides d'aluminium, d'yttrium et de cérium, sous forme de poudres, sont mélangés, broyés et chauffés à hautes températures, par exemple à des températures supérieures à 1600 °C, pour former une poudre de particules ayant la composition et la phase cristalline souhaitées. Un recuit de la poudre est ensuite réalisé sous atmosphère réductrice, généralement sous hydrogène ($H_2$), pour réduire les ions $Ce^{4+}$, qui n'ont pas de propriété de photoluminescence et qui agissent comme des pièges pour les porteurs de charge, en ions $Ce^{3+}$ qui ont les propriétés de photoluminescence recherchées. Les particules photoluminescentes obtenues ont une structure cristalline de bonne qualité. Elles peuvent alors être dispersées dans une matrice, par exemple de la résine, pour former un revêtement photoluminescent.

Les procédés de fabrication de particules d'un matériau photoluminescent comprenant des réactions à l'état solide permettent de fabriquer des particules dont la taille moyenne est supérieure au micromètre, par exemple variant de 10 $\mu$m à 15 $\mu$m. Pour certaines applications, il est souhaitable de fabriquer des particules dont la taille moyenne est inférieure à 1 pm, de telles particules étant appelées indifféremment nanoparticules, particules nanométriques ou particules submicroniques par la suite. C'est le cas notamment lorsque l'on souhaite réaliser une composition fluide ou visqueuse comprenant les particules photoluminescentes de façon à pouvoir mettre en œuvre un procédé d'application des particules photoluminescentes dit additif, par exemple par impression directe de la composition comprenant les particules photoluminescentes aux emplacements souhaités. Toutefois, la réalisation d'une composition fluide comprenant des particules photoluminescentes qui soit stable dans le temps nécessite l'utilisation de nanoparticules.

Pour fabriquer des nanoparticules, il est connu de mettre en oeuvre une méthode de synthèse dite descendante ou "Top-down" qui consiste à broyer des particules du matériau photoluminescent de taille moyenne supérieure au micromètre obtenues par des réactions à l'état solide, par exemple dans un broyeur à billes, de façon à réduire la taille moyenne des particules. Toutefois, l'opération de broyage entraîne la formation de défauts à la surface des particules obtenues d'où il résulte une diminution des performances de photoluminescence des nanoparticules photoluminescentes, notamment du rendement quantique externe des particules. En outre, des phénomènes d'agglomération des particules nanométriques obtenues par broyage peuvent être observés, ce qui entraîne la formation d'amas de particules de grandes dimensions.

Il est connu de réaliser des particules d'un matériau photoluminescent par des méthodes dites ascendantes ou "Bottom-up" qui permettent d'obtenir des particules submicroniques. Les méthodes de synthèse "Bottom-up" sont des méthodes de synthèse chimique qui reposent sur l'assemblage d'entités chimiques de petites dimensions (atomes ou molécules) pour réaliser des objets de plus grandes tailles, des nanoparticules en l'occurrence. Parmi les méthodes ascendantes, on peut citer par exemple le procédé sol-gel et le procédé solvothermal ou hydrothermal. Le point commun des méthodes ascendantes réside dans le fait que les synthèses de nanoparticules sont généralement réalisées à des températures plus basses comparées à celles des réactions à l'état solide. Du fait de ces basses températures de synthèse, les nanoparticules photoluminescentes souffrent généralement d'un faible degré de cristallinité donnant lieu à des défauts de structure qui sont souvent associés à des "pièges" de porteurs de charge ou de luminescence. Ainsi, les performances en termes de rendement lumineux des nanoparticules photoluminescentes obtenues par ces méthodes sont nettement inférieures à celles des particules photoluminescentes de taille moyenne supérieure au micromètre fabriquées par réactions en phase solide.

Il serait souhaitable d'obtenir une poudre de nanoparticules d'un matériau photoluminescent dont les performances, notamment en termes de rendement lumineux, sont supérieures à celles obtenues pour des nanoparticules du même matériau photoluminescent obtenues par les méthodes ascendantes.

Des particules photoluminescentes modifiées en surface et un procédé pour leur production sont connus de US 8,801,968 B2.

Résumé

Un objet d'un mode de réalisation vise à pallier tout ou partie des inconvénients relatifs aux procédés de fabrication de particules photoluminescentes décrits précédemment.

Un autre objet d'un mode de réalisation est que la taille moyenne des particules est inférieure à 1 $\mu$m.

Un autre objet d'un mode de réalisation est que 100 % des particules ($d_{100}$) ont une taille inférieure à 1 $\mu$m.

Un autre objet d'un mode de réalisation consiste à remédier aux défauts de surface des nanoparticules obtenues après une étape de broyage.

Un autre objet d'un mode de réalisation est que le rendement quantique externe des particules nanométriques est supérieur à 60 % et que le rendement quantique interne est au moins égal à 70 %.

Un autre objet d'un mode de réalisation est de permettre la réalisation de dispersions colloïdales stables dans le temps.

Un autre objet d'un mode de réalisation est que la surface des nanoparticules synthétisées soit compatible avec le(s) solvant(s) et/ou les encapsulants utilisés pour la mise en oeuvre d'un luminophore.

Un autre objet d'un mode de réalisation est que les dispersions de nanoparticules photoluminescentes soient compatibles avec la méthode de dépôt du luminophore sur les diodes électroluminescentes.

Un autre objet d'un mode de réalisation est que les nanoparticules photoluminescentes forment une suspension stable dans une composition de résine photosensible.

Un autre objet d'une mode de réalisation est que les nanoparticules photoluminescentes forment une suspension stable dans une composition de résine photosensible de type acrylate.

Ainsi, un mode de réalisation prévoit un procédé de fabrication de nanoparticules d'un matériau photoluminescent, comprenant les étapes successives suivantes :

a) former des particules nanométriques dudit matériau photoluminescent ;
b) réaliser une dispersion contenant les particules dans un solvant non aqueux, la dispersion contenant, en outre, au moins un agent de surface.
c) placer la dispersion dans un autoclave à une pression comprise entre 2 MPa et 100 MPa ; et
d) récupérer les particules.

Selon un mode de réalisation, l'étape b) est précédée d'un traitement de surface des particules nanométriques par un précurseur de silice.

Selon un mode de réalisation, l'agent de surface est un agent de couplage de type silane qui est un composé organo-fonctionnel ayant la formule chimique suivante :

$$R_nSiX_{4-n}$$

où n est égal à 1, 2 ou 3, X désigne un groupement hydrolysable, et R est un groupement organique non hydrolysable.

Selon un mode de réalisation, X est un groupement alcoxy, un groupement halogénure ou un groupement amine.

Selon un mode de réalisation, le solvant non aqueux est un alcool.

Selon un mode de réalisation, l'étape a) comprend le broyage de particules dudit matériau photoluminescent dont la taille moyenne est supérieure à 1 $\mu$m pour obtenir les particules nanométriques.

Selon un mode de réalisation, les particules dudit matériau photoluminescent dont la taille moyenne est supérieure à 1 $\mu$m sont broyées en milieu humide.

Selon un mode de réalisation, les particules dudit matériau photoluminescent dont la taille moyenne est supérieure à 1 $\mu$m sont broyées dans un solvant différent du solvant non aqueux utilisé à l'étape b).

Selon un mode de réalisation, la durée de l'étape c) est comprise entre 30 minutes et 48 heures.

Selon un mode de réalisation, la température dans l'autoclave est comprise entre 25 °C et 300 °C.

Selon un mode de réalisation, le matériau photoluminescent est un aluminate, un silicate, un nitrure, un oxynitrure, un fluorure ou un sulfure.

Selon un mode de réalisation, le matériau photoluminescent comprend majoritairement un oxyde d'yttrium et d'aluminium ou un oxyde de lutécium et d'aluminium contenant, en outre, au moins un des éléments suivants : cérium, europium, chrome, néodyme, terbium, dysprosium, praséodyme ou gadolinium.

Selon un mode de réalisation, le procédé comprend, en outre, avant l'étape c), une étape de mélange et de traitement dans l'autoclave des particules nanométriques en présence de la totalité ou une partie des précurseurs utilisés pour former les particules nanométriques.

Selon un mode de réalisation, le procédé comprend, en outre, avant l'étape c), une étape de mélange des particules nanométriques avec au moins une substance photoluminescente.

Selon un mode de réalisation, la substance photoluminescente est une boîte quantique.

Selon un mode de réalisation, les particules nanométriques sont des boîtes quantiques.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, sous la forme d'un schéma-bloc, un mode de réalisation d'un procédé de fabrication de particules nanométriques d'un matériau photoluminescent ;

la figure 2 est une vue en coupe, partielle et schématique, d'un autoclave ;

la figure 3 est une vue en coupe, partielle et schématique, de nanoparticules d'un matériau photoluminescent obtenues par le procédé illustré en figure 1 ;

la figure 4 est une vue en coupe, partielle et schématique, d'un détail d'une partie d'une nanoparticule représentée en figure 3 ;

les figures 5 à 7 sont des vues en coupe, partielles et schématiques, d'une particule d'un matériau photoluminescent obtenues par des variantes du procédé illustré en figure 1 ;

la figure 8 représente, sous la forme d'un schéma-bloc, un mode de réalisation plus détaillé d'une étape du procédé de fabrication de nanoparticules illustré en figure 1 ;

la figure 9 représente de façon schématique une nanoparticule aux étapes d'un mode de réalisation du procédé illustré en figure 1 ;

les figures 10 à 12 sont des courbes de distribution de tailles de particules photoluminescentes ;

la figure 13 représente des courbes d'évolution de l'intensité de photoluminescence en fonction de la longueur d'onde du rayonnement émis par des matériaux photoluminescents ;

la figure 14 est un diffractogramme de rayons X représentatif d'un exemple de nanoparticules photoluminescentes ;

les figures 15 à 18 sont des courbes de distribution de tailles de particules photoluminescentes ;

la figure 19 représente des courbes d'évolution de l'intensité de photoluminescence en fonction de la longueur d'onde du rayonnement émis par des matériaux photoluminescents ;

les figures 20, 21 et 22 sont des figures analogues respectivement aux figures 17, 18 et 19 pour un autre matériau photoluminescent ;

les figures 23, 24 et 25 sont des figures analogues respectivement aux figures 17, 18 et 19 pour un autre matériau photoluminescent ;

les figures 26, 27 et 28 sont des figures analogues respectivement aux figures 17, 18 et 19 pour un autre matériau photoluminescent ; et

les figures 29 à 32 sont des courbes de distribution de tailles de particules photoluminescentes.

Description détaillée

Par souci de clarté, de mêmes éléments ont été désignés par de mêmes références aux différentes figures. En outre, dans la suite de la description, les expressions "sensiblement", "environ" et "approximativement" signifient "à 10 % près".

On entend par particules d'un matériau des éléments unitaires du matériau. Le terme "particule" tel qu'utilisé dans le cadre de la présente demande doit être compris dans un sens large et correspond non seulement à des particules compactes ayant plus ou moins une forme sphérique mais aussi à des particules anguleuses, des particules aplaties, des particules en forme de flocons, des particules en forme de fibres, ou des particules fibreuses, etc. On comprendra que la "taille" des particules dans le cadre de la présente invention signifie la plus petite dimension transversale des particules. A titre d'exemple, dans le cas de particules en forme de fibres, la taille des particules correspond au diamètre des fibres.

Par le terme "taille moyenne", on entend selon la présente invention la taille de la particule qui est supérieure à la taille de 50 % en volume des particules et inférieure à la taille de 50 % en volume des particules d'une distribution de particules. Ceci correspond au $d_{50}$. Ainsi, une taille moyenne qui est inférieure à la taille de 100 % en volume des particules d'une distribution correspond à $d_{100}$. On entend par particule micronique une particule dont la taille moyenne est comprise entre 1 μm et 100 μm, typiquement entre 1 μm et 50 μm. On entend par nanoparticules des particules dont la taille moyenne est inférieure à 1 pm, de préférence comprise entre 5 nm et 500 nm. La granulométrie des particules microniques peut être mesurée par granulométrie laser en utilisant, par exemple, un Malvern Mastersizer 2000. La granulométrie des particules submicroniques ou nanoparticules peut être mesurée par Diffusion Dynamique de la Lumière (DDL) en utilisant, par exemple, un Zetasizer Nano ZS de Malvern.

Un mode de réalisation du procédé de fabrication de nanoparticules d'un matériau photoluminescent comprend la réalisation d'une dispersion de nanoparticules dans un solvant non aqueux avec au moins un agent de surface, et le maintien de la dispersion dans un autoclave à une température comprise entre 50 °C et 300 °C et une pression comprise entre 2 MPa et 100 MPa, de préférence entre 2 MPa et 10 MPa, de 30 minutes à 48 heures. Les particules nanométriques peuvent être obtenues par broyage de particules de taille moyenne supérieure à 1 μm obtenues par des procédés de fabrication à l'état solide. A titre de variante, les nanoparticules peuvent être formées directement par des méthodes ascendantes.

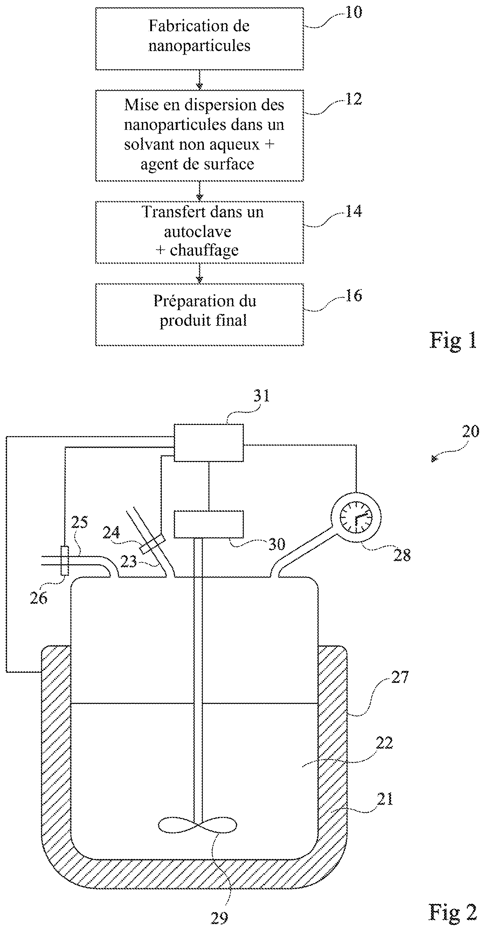

La figure 1 représente, sous la forme d'un schéma-bloc, un mode de réalisation d'un procédé de fabrication de nanoparticules d'un matériau photoluminescent. Le procédé comprend des étapes successives 10 à 16.

A l'étape 10, des nanoparticules d'un matériau photoluminescent sont fabriquées.

Selon un mode de réalisation, le matériau photoluminescent est un aluminate, un silicate, un nitrure, un oxynitrure, un fluorure ou un sulfure. A titre d'exemple, le matériau photoluminescent est adapté à émettre de la lumière à une longueur d'onde dans la gamme allant de 400 nm à 700 nm sous excitation lumineuse à une longueur d'onde dans la gamme allant de 250 nm à 500 nm, de préférence de 360 nm à 480 nm.

Selon un mode de réalisation, le matériau photoluminescent comprend majoritairement un aluminate, notamment un grenat d'aluminium et d'yttrium selon la formule (1) suivante :

$$(Y_{(1-x)}R^1_x)_3(Al_{(1-y)}R^2_y)_5O_{12} \qquad (1)$$

ou un grenat d'aluminium et de lutécium selon la formule (2) suivante :

$$(Lu_{(1-x)}R^1_x)_3(Al_{(1-y)}R^2_y)_5O_{12} \qquad (2)$$

où $R^1$ et $R^2$ sont indépendamment choisis parmi les éléments comprenant les terres rares, les alcalino-terreux et les métaux de transition et x et y varient chacun et indépendamment de 0 à 1. De préférence, $R^1$ et $R^2$ sont indépendamment choisis parmi le groupe comprenant le cérium, le samarium, le gadolinium, le silicium, le baryum, le terbium, le strontium, le chrome, le praséodyme et le gallium.

A titre d'exemple de nitrures absorbant et émettant de la lumière dans les gammes de longueur d'onde souhaitées, on peut citer : $CaAlSiN_3$:Eu, $(Ca,Sr)AlSiN_3$:Eu, $Ca_2Si_5N_8$:Eu ou $(Ca,Sr)Si_5N_8$:Eu.

A titre d'exemple de fluorures absorbant et émettant de la lumière dans les gammes de longueur d'onde souhaitées, on peut citer les fluorures de formule $X_2MF_6$:Mn (où X peut être K ou Na et M peut être Si, Ge, Sn ou Ti) .

A titre d'exemple de sulfures absorbant et émettant de la lumière dans les gammes de longueur d'onde souhaitées, on peut citer : CaS:Eu, SrCa:Eu, (Sr,Ca)S:Eu et $SrGa_2S_4$:Eu.

A titre d'exemple d'aluminates absorbant et émettant de la lumière dans les gammes de longueur d'onde souhaitées, on peut citer : $Y_3Al_5O_{12}$:Ce, $(Y,Gd)_3Al_5O_{12}$:Ce, $Tb_3Al_5O_{12}$, $(Y,Tb)_3Al_5O_{12}$, $Lu_3Al_5O_{12}$ :Ce et $Y_3(Al,Ga)_5O_{12}$.

A titre d'exemple de silicates absorbant et émettant de la lumière dans les gammes de longueur d'onde souhaitées, on peut citer : $(Sr,Ba)_2SiO_4$:Eu, $Sr_2SiO_4$:Eu, $Ba_2SiO_4$:Eu, $Ca_2SiO_4$:Eu, $Ca_3SiO_5$:Eu et $Sr_3SiO_5$:Eu.

A l'étape 12, on forme une dispersion colloïdale des particules photoluminescentes dans un solvant non aqueux, c'est-à-dire comprenant moins de 0,02 % en poids d'eau. Le solvant non aqueux est de préférence un solvant non aqueux polaire et protique. Selon un mode de réalisation, le solvant non aqueux est un alcool, notamment choisi dans le groupe comprenant le méthanol, l'éthanol, le propanol, le butanol, le pentanol, l'hexanol et l'isopropanol. Selon un mode de réalisation, la dispersion colloïdale comprend de 10 mg à 100 mg de particules photoluminescentes par mL de solvant (10 mg/mL - 100 mg/mL).

A l'étape 14, on réalise une fonctionnalisation des particules nanométriques. Dans ce but, la dispersion colloïdale est disposée dans un autoclave.

A l'étape 16, on prépare le produit final. Le produit final est par exemple sous forme d'une solution liquide, une solution visqueuse, une poudre, un revêtement ou un dépôt sur substrat, notamment un substrat de diode électroluminescente, sous forme de film solide, etc.

La figure 2 représente un mode de réalisation d'un autoclave 20 pouvant être utilisé à l'étape 14. L'autoclave 20 comprend une enceinte 21 dans laquelle est disposé le produit 22 à traiter. Une conduite 23 permet l'apport de gaz dans l'enceinte 21. L'ouverture et la fermeture de la conduite 23 sont commandées par une vanne 24. Une conduite 25 permet le prélèvement d'échantillons dans l'enceinte 21. L'ouverture et la fermeture de la conduite 25 sont commandées par une vanne 26. L'enceinte 21 est partiellement entourée par un collier chauffant 27. Un capteur de pression 28 permet la mesure de la pression dans l'enceinte 21. Un agitateur 29 entraîné par un moteur 30 permet d'agiter le produit 22 dans l'enceinte 21. Un module de commande 31, comprenant par exemple un ordinateur, est relié au capteur de pression 28, au collier chauffant 27, aux vannes 24, 26 et au moteur 30. Le module de commande 31 est adapté à commander le collier chauffant 27 et les vannes 24, 26. Le module de commande 31 permet de réguler la température et la pression dans l'enceinte 21 et peut commander le démarrage et l'arrêt de l'agitateur 29.

En considérant à nouveau la figure 1, selon un mode de réalisation, la pression dans l'autoclave est maintenue sensiblement constante pendant toute la durée de l'étape 14. A titre d'exemple, la pression dans l'autoclave peut varier entre 20 bars (2 MPa) et 100 bars (10 MPa) selon le solvant utilisé et la température de chauffe. La pression peut également être ajustée par l'introduction d'un gaz, par exemple l'azote, dans l'autoclave. Selon un mode de réalisation, la température dans l'autoclave est maintenue sensiblement constante pendant toute la durée de l'étape 14. A titre d'exemple, la température dans l'autoclave est comprise entre 25 °C et 300 °C, de préférence entre 150 °C et 250 °C. Une agitation des particules dans la dispersion peut être réalisée dans l'autoclave.

Selon un mode de réalisation, au moins un agent de surface est ajouté à la dispersion colloïdale de particules photoluminescentes avant son placement dans l'autoclave.

Selon un mode de réalisation, l'agent de surface est un agent de couplage de type silane. Par l'expression "agent de couplage de type silane", "agent de couplage au silane" ou "agent de couplage silane", on entend selon la présente description un réactif capable de se lier par des liaisons chimiques ou des liaisons physiques avec une matrice ou un solvant dans lequel sont dispersées les particules et capable de se lier chimiquement avec la surface des particules. Chaque agent de couplage silane comprend une première partie capable de se lier avec la matrice ou le solvant et une deuxième partie capable de se lier avec la surface des particules. Selon un mode de réalisation, la dispersion colloïdale comprend de 1 mg à 100 mg d'agents de couplage par mL de solvant. Le rapport massique entre l'agent de couplage silane et les nanoparticules luminescentes peut varier entre 5 et 0,01, de préférence entre 3 et 0,1. Les agents de couplage silane tendent à se répartir à la périphérie de chaque particule photoluminescente et à former une couche plus ou moins dense entourant chaque particule.

Un agent de couplage au silane est un composé organo-fonctionnel ayant la formule chimique (3) suivante :

$$R_nSiX_{4-n} \qquad (3)$$

où n est égal à 1, 2 ou 3, X désigne un groupement hydrolysable, notamment un groupement alcoxy, un groupement halogénure ou un groupement amine, et R est un groupement organique non hydrolysable. A titre d'exemple, l'organo-silane est de formule $R_nSi(OR')_{4-n}$.

Selon un autre mode de réalisation, l'agent de surface est un composé ayant la formule chimique (4) suivante :

$$R\text{-}Y\text{-}R' \qquad (4)$$

Y est une chaîne hydrocarbure pouvant contenir aussi au moins un atome d'oxygène. Y est appelé espaceur. L'espaceur permet d'ajuster dans certains cas le caractère hydrophile/hydrophobe de la particule photoluminescente. L'espaceur peut en outre permettre d'ajuster la distance entre les particules photoluminescentes. R et R' peuvent être identiques et appartiennent aux groupements chimiques suivants : thiol (-SH), acide carboxylique (-COOH), alcool (-OH), amine (-NH2) ou groupement de type acrylate. Ils peuvent aussi être des groupements fonctionnels non réactifs comme le polyéthylène glycol (-PEG) ou un groupement aromatique. R et R' peuvent également être monofonctionnels (ayant un seul groupement fonctionnel), bi-fonctionnels (2 groupements fonctionnels), tri-fonctionnels (3 groupements fonctionnels) ou tétra-fonctionnels (4 groupements fonctionnels).

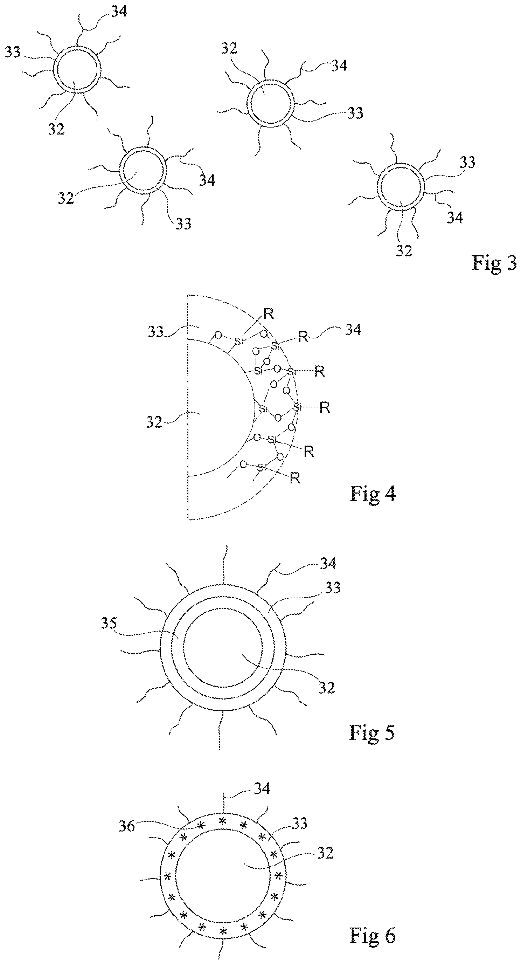

La figure 3 est une vue en coupe, partielle et schématique, de nanoparticules photoluminescentes obtenues à la fin de l'étape 14 selon un mode de réalisation du procédé de fabrication de la dispersion colloïdale. Chaque particule 32 du matériau photoluminescent est entourée d'une couche 31 d'agents de couplage. Le recouvrement de chaque particule 32 par les agents de couplage peut être plus ou moins complet. Toutes les parties des agents de couplage qui ne sont pas capables de se lier avec la particule sont orientées vers l'extérieur de la particule, ce qui est illustré par les appendices 34 en figure 3.

Selon un mode de réalisation, les agents de couplage silane sont choisis dans le groupe comprenant par exemple : n-propyltriméthoxysilane, allyltriméthoxysilane, n-propyltriéthoxysilane, triméthoxy(7-octen-1-yl)silane, triméthoxy(octadécyl)silane, n-octyltriméthoxysilane, n-octyltriéthoxysilane, méthoxy(triéthylèneoxy)propyltriméthoxysilane, 3-aminopropyltriméthoxysilane, phénylriméthoxysilane, diméthoxy(méthyl)octylsilane, 3-mercaptopropyltriméthoxysilane, 3-(méthacryloyloxy)-propyltriméthoxysilane, 3-isocyanatopropyltriéthoxysilane, 3-isocyanatopropyltriméthoxysilane, 2-[méthoxy(polyéthylèneoxy)6-9propyl]triméthoxysilane, 3-glycidoxypropyltriméthoxysilane, N-(3-acryloxy-2-hydroxypropyl)-3-aminopropyltriéthoxysilane et bis[3-(triéthoxysilyl)propyl]urée.

Selon un mode de réalisation, les agents de couplage silane peuvent être des chlorosilanes carbonés comme par exemple : chloro(diméthyl)octadécylsilane, chloro(dodécyl)diméthylsilane ou chloro(décyl)diméthylsilane ou des chlorosilanes fluorés comme par exemple : le chloro-diméthyl(3,3,3trifluoropropyl)silane ou perfluorodécyltrichlorosilane.

Selon un mode de réalisation, les agents de couplage peuvent, en outre, réagir entre eux à la surface des particules et former un nouveau composé qui entoure, en totalité ou en partie, chaque particule.

Selon un mode de réalisation, les organosilanes réagissent dans le solvant non aqueux pour former des liaisons Si-O-Si. De façon avantageuse, la réaction des organosilanes en milieu non aqueux n'entraîne pas la formation de silanols (Si-OH). Il est admis que la présence de groupements de type hydroxy (-OH), comme par exemple les groupements Si-OH, à la surface des particules photoluminescentes a un effet négatif sur le rendement lumineux des particules (notamment parce que ces groupements forment des pièges pour les porteurs de charge).

A titre d'exemple, il est connu que la réaction d'un chlorure de Silicium ($SiCl_4$) avec un éther anhydre de formule R-O-R peut donner lieu à des particules de $SiO_2$ avec des groupements de surface de type Si-OR seulement selon les équations (5), (6) et (7) suivantes :

Hydrolyse :

$$Si\text{-}Cl + R\text{-}O\text{-}R \rightarrow Si\text{-}OR + R\text{-}Cl \qquad (5)$$

Condensation *via* :

$$Si\text{-}OR + Si\text{-}Cl \rightarrow Si\text{-}O\text{-}Si + R\text{-}Cl \qquad (6)$$

ou *via* :

$$Si\text{-}OR + Si\text{-}OR \rightarrow Si\text{-}O\text{-}Si + R\text{-}O\text{-}R \qquad (7)$$

La figure 4 est une vue en coupe, partielle et schématique, d'une particule 32 entourée d'une couche 33 de siloxane plus au moins dense obtenue par formation de liaisons Si-O-Si entre des agents de couplage au silane. Les groupements R sont orientés vers l'extérieur de la particule 32.

Selon une variante, l'étape 14 peut inclure une étape de traitement de surface avec toute ou une partie des précurseurs utilisés pour construire la particule photoluminescente. Cette étape peut être réalisée avant ou pendant l'étape de fonctionnalisation, de préférence avant l'étape de fonctionnalisation de surface. Par exemple, un traitement de surface en présence d'une source d'yttrium, d'aluminium, de cérium et d'oxygène peut être utilisé pour traiter la surface des nanoparticules de YAG:Ce. Pour des nanoparticules de $Ca_2MgSi_2O_7$:Eu, toute ou une partie des sources de silicium, de magnésium, de calcium, d'europium et d'oxygène peuvent être mélangées avec les nanoparticules chauffées dans l'autoclave comme décrit précédemment. Ces précurseurs vont réagir entre eux dans la dispersion et former une couche qui entoure, en totalité ou en partie, chaque particule.

La figure 5 est une vue en coupe, partielle et schématique, d'une particule 32 obtenue à la fin de l'étape 14 lorsqu'une étape de traitement de surface avec tout ou une partie des précurseurs utilisés pour construire la particule photoluminescente a été réalisée. Ces précurseurs ont réagi entre eux dans la dispersion et ont formé une couche 35 qui entoure, en totalité ou en partie, la particule 32.

Selon une autre variante, une ou plusieurs substances photoluminescentes peuvent être rajoutées au mélange de l'étape 14. La substance ou les substances photoluminescentes peuvent être de type organique, inorganique ou hybride émettant ou pas à la même longueur d'onde d'émission que la particule 20. A la fin de l'étape 14, la substance photoluminescente sera située à l'intérieur de la couche formée par les agents de couplage ou à l'extérieur de cette couche.

La figure 6 est une vue en coupe, partielle et schématique, d'une particule 32 obtenue à la fin de l'étape 14 lorsque des substances photoluminescentes sont ajoutées au mélange à l'étape 14. Les substances photoluminescentes 36 ont été piégées dans la couche 33.

Selon un mode de réalisation, la substance photoluminescente peut être une boîte quantique. La boîte quantique peut être liée à la couche formée par les agents de couplage par des liaisons chimiques covalentes. Par exemple, le 3-mercaptopropyltriméthoxysilane peut être utilisé comme agent de couplage. Les groupements triméthoxysilane formeront des liaisons covalentes avec la surface de la particule photoluminescente tandis que le groupement thiol (-SH) orienté vers l'extérieur de la particule va former une liaison covalente avec la surface de la boîte quantique.

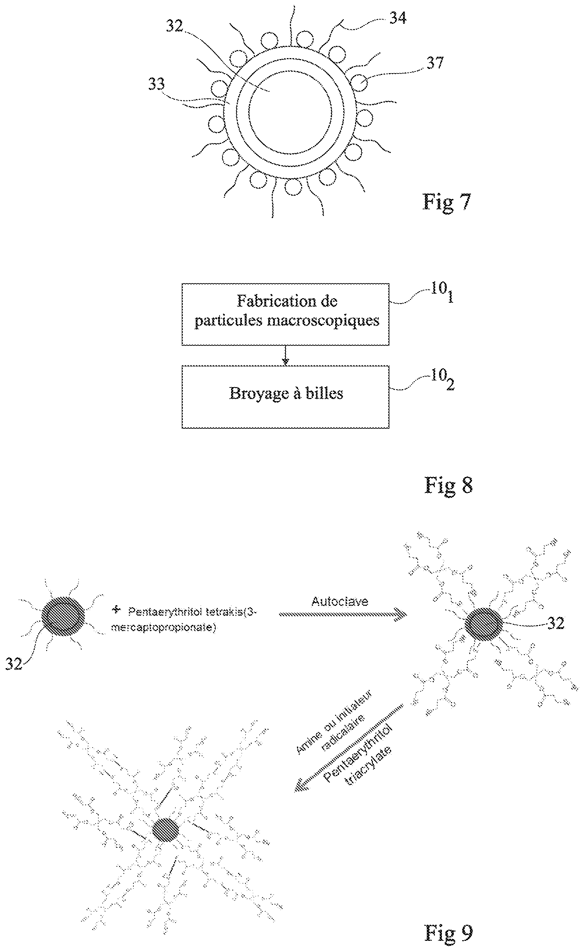

La figure 7 est une vue en coupe, partielle et schématique, d'une particule 32 obtenue à la fin de l'étape 14 pour laquelle des boîtes quantiques 37 sont liées à la surface de la couche 33.

La durée de l'étape 14 peut être comprise entre 30 minutes et plusieurs jours, de préférence entre 30 minutes et 48 heures, de préférence entre 10 heures et 20 heures. La durée de chauffage dépend notamment de la température de chauffage, du solvant et des agents de surface utilisés.

Selon un mode de réalisation, l'étape 14 de fonctionnalisation peut être précédée d'une étape supplémentaire de traitement de la surface des nanoparticules obtenues à l'étape 12. Cette étape peut comprendre le mélange de la dispersion de nanoparticules avec des précurseurs de silice à température ambiante pendant une durée qui varie de 1 heure à 24 heures. Le précurseur de la silice est par exemple le TEOS. La réaction peut alors être réalisée en présence d'ammoniaque ($NH_4OH$) selon la méthode de Stöber par exemple. L'étape de prétraitement est suivie de la récupération et du nettoyage des nanoparticules pour éliminer les précurseurs de silice qui n'ont pas réagi avec la surface des particules, et éventuellement de l'ammoniaque, et l'étape 14 de fonctionnalisation peut être réalisée comme cela a été décrit précédemment.

L'étape 16 comprend la préparation d'un produit final adapté à l'application visée. L'étape 16 peut comprendre la récupération des particules dans la dispersion colloïdale obtenue à la fin de l'étape 14. L'étape de récupération peut comprendre une étape de précipitation des nanoparticules, par exemple par ajout d'un anti-solvant pour les nanoparticules. On entend par "anti-solvant" tout solvant qui ne présente pas d'affinité "chimique" avec les nanoparticules. Le choix de cet anti-solvant va dépendre de la nature et de la chimie de surface des nanoparticules. Ces anti-solvants sont généralement des solvants polaires aprotiques comme l'acétone ou des solvants polaires protiques comme l'éthanol. A titre de variante, la phase solide contenant les nanoparticules peut être récupérée par centrifugation. L'étape 16 peut être suivie d'une étape de purification des particules, notamment pour retirer des précurseurs qui n'auraient pas réagi et les produits de réactions parasites ainsi que le solvant ou les solvants utilisés dans l'étape 14. Les nanoparticules sont ensuite séchées, par exemple à une température comprise entre 25 °C et 80 °C, pendant une durée comprise entre 1 h et 12 h. Une poudre de nanoparticules est alors obtenue.

La poudre de nanoparticules obtenue à l'étape 16 peut être ajoutée à un solvant, contenant éventuellement en outre un liant, par exemple une résine, pour former une composition de particules photoluminescentes fluide ou visqueuse. Les agents de surface liés aux particules photoluminescentes peuvent être choisis pour améliorer la compatibilité entre les particules photoluminescentes et le solvant et/ou le liant, par exemple pour augmenter la dispersion des particules photoluminescentes dans le solvant et/ou le liant.

Le procédé d'application de la composition photoluminescente, notamment pour former un revêtement, peut correspondre à un procédé dit additif, par exemple par impression directe de la composition photoluminescente aux emplacements souhaités, par exemple par impression à jet d'encre, héliographie, sérigraphie, flexographie, revêtement par pulvérisation (en anglais spray coating), dépôt de gouttes (en anglais drop-casting) ou par trempage du substrat dans la solution de nanoparticules photoluminescentes (en anglais dip-coating).

La figure 8 représente, sous la forme d'un schéma-bloc, un mode de réalisation de l'étape 10 décrite précédemment de fabrication de nanoparticules du matériau photoluminescent. Le procédé comprend des étapes successives $10_1$ et $10_2$.

A l'étape $10_1$, des particules de taille moyenne supérieure à 1 $\mu$m sont réalisées par un procédé connu de fabrication de particules du matériau photoluminescent. A titre d'exemple, le procédé comprend des réactions à l'état solide. A titre d'exemple, des précurseurs solides des composants du matériau photoluminescent sous forme de poudres sont mélangés, broyés et chauffés à hautes températures, par exemple à des températures supérieures à 1600 °C, pour former une poudre de particules ayant la composition et la phase cristalline souhaitées. Un recuit de la poudre peut être réalisé sous atmosphère réductrice, par exemple sous hydrogène ($H_2$).

A la fin de l'étape $10_1$, la taille moyenne des particules photoluminescentes est supérieure à 1 $\mu$m et peut être comprise entre 10 $\mu$m et 15 $\mu$m.

A l'étape $10_2$, la taille moyenne des particules photoluminescentes obtenues à l'étape $10_1$ est réduite par broyage des particules, par exemple en utilisant un broyeur à billes ou à boulets. Le broyage est de préférence un broyage humide dans lequel les particules sont dispersées dans un solvant. Le solvant est de préférence un solvant non aqueux, en particulier un solvant non aqueux polaire et protique. Selon un mode de réalisation, le solvant est un alcool, de préférence choisi dans le groupe comprenant le méthanol, l'éthanol, le propanol, le butanol, le pentanol, l'hexanol et l'isopropanol, en particulier l'éthanol. A la fin de l'étape $10_2$, la taille moyenne des particules photoluminescentes est inférieure à 1 pm, par exemple comprise entre 100 nm et 500 nm.

Le solvant utilisé à l'étape $10_2$ peut être le même que celui utilisé par la suite à l'étape 12. Lorsque le solvant utilisé à l'étape 12 est le même que celui utilisé à l'étape $10_2$, la dispersion colloïdale de nanoparticules photoluminescentes utilisées à l'étape 12 peut correspondre à la dispersion obtenue à la fin de l'étape $10_2$. Toutefois, il peut être avantageux d'utiliser à l'étape 12 un solvant qui est différent du solvant utilisé à l'étape $10_2$. En effet, il peut être souhaitable d'utiliser un premier solvant à l'étape $10_2$ qui améliore les performances de l'opération de broyage, par exemple un solvant ayant une faible viscosité, et un deuxième solvant plus adapté au traitement réalisé à l'étape 14, par exemple un solvant ayant une température d'ébullition plus élevée que le solvant utilisé à l'étape $10_2$.

Selon un autre mode de réalisation, le procédé mis en oeuvre à l'étape 10 de fabrication de nanoparticules du matériau photoluminescent aboutit directement à l'obtention de particules nanométriques sensiblement sans formation de particules dont la taille moyenne est supérieure au micromètre. A titre d'exemple, le procédé de fabrication des nanoparticules est un procédé hydrothermal. Selon un mode de réalisation, les nanoparticules sont des boîtes quantiques.

Les boîtes quantiques sont des nanocristaux de semiconducteurs purs (Si, Ge) ou de composés de type II-VI (CdS, CdSe, CdTe, ZnO, ZnSe, ZnS), III-V (GaAs, InP, InAs, GaN), IV-VI (PbS, PbSe, PbTe), I-VII (CuCl), V-VI ($Bi_2Te_3$) ou II-V ($Cd_3As$, $Zn_3P_2$, $Zn_3As_2$), dont le diamètre est généralement compris entre 2 nm et 10 nm. Conséquence directe du phénomène de « confinement quantique », ces matériaux présentent alors des propriétés de fluorescence ajustables par le contrôle de leur taille. Deux grandes méthodes de synthèse colloïdale de boîtes quantiques ont été développées au cours des quinze dernières années : les synthèses dites "organométalliques" et "hydrothermales". La synthèse organométallique est basée sur l'injection rapide d'un précurseur A à haute température (270 °C-300 °C) et d'un précurseur B (par exemple, dans le cas de CdSe, A correspond à $Se^{2-}$ et B correspond à $Cd^{2+}$) dans des solvants coordinants, tels que l'oxyde de trioctylphosphine (TOPO), l'hexadécylamine (HDA), l'oleylamine, ou non coordinant tel que le 1-octadécène (ODE). La synthèse hydrothermale se fait en milieu aqueux et l'injection du précurseur se fait généralement à température ambiante. Le mélange est ensuite chauffé à reflux (100 °C) ou à des températures supérieures à 150 °C dans un autoclave. La synthèse la plus couramment utilisée pour la fabrication des boîtes quantiques, et qui permet d'atteindre les rendements lumineux les plus élevés, est la méthode de type organométallique. Cependant, cette méthode génère des particules hydrophobes qui sont uniquement miscibles avec les solvants organiques de type apolaires (toluène, chloroforme, hexane, etc). Malheureusement, la plupart de ces solvants sont toxiques pour l'homme et l'environnement. Afin de rendre les particules miscibles avec d'autres solvants de type polaire (peu ou pas toxiques), un échange de ligand est nécessaire. Il est à noter que l'échange de ligand de surface est très souvent accompagné d'une baisse de rendement quantique de photoluminescence des boîtes quantiques. De même, les ligands hydrophobes issus de la synthèse des boîtes quantiques (par voie organométallique) ne sont pas compatibles avec tous types d'encapsulants utilisés pour la mise en forme des particules, par exemple, les résines silicones. Quand les boîtes quantiques hydrophobes sont mélangées avec une résine silicone, une forte agrégation et floculation de particules est observée. Par ailleurs, les boîtes quantiques souffrent généralement d'une mauvaise stabilité dans le temps à cause de l'oxydation des métaux de surface ce qui conduit à une baisse importante du rendement lumineux dans le temps. Il est donc souhaitable de mettre au point un procédé versatile de traitement de surface des boîtes quantiques qui permet à la fois de protéger les boîtes quantiques contre l'oxydation et de les doter de fonctions de surface spécifiques qui permettent de les rendre miscibles avec leur milieu de dispersion (encapsulant, solvant, liant, composition contenant des résines, etc) selon l'application et la mise en forme souhaitées sans que cela conduise à une perte de rendement lumineux des particules de départ (avant traitement de surface).

Dans le cas où la nanoparticule est une boîte quantique, d'autres agents de couplage spécifiques, autres que les organosilanes, peuvent être utilisés. Selon un mode de réalisation, ces agents de couplage spécifiques peuvent au moins avoir deux fonctions de type thiol (-SH). Les agents de couplage suivants peuvent être utilisés : 1,6-hexanedithiol (qui possède deux fonctions thiols), triméthylolpropane tris(3-mercaptopropionate) (qui possède trois fonctions thiols) et pentaérythritol tétrakis(3-mercaptopropionate) (qui possède quatre fonctions thiols). Au moins l'une des fonctions thiols réagit à la surface de nanoparticules tandis que les fonctions thiols restantes sont orientées vers l'extérieur de la particule et peuvent réagir avec des monomères spécifiques afin de réaliser une couche organique autour de la boîte quantique. Selon un mode de réalisation, les monomères spécifiques doivent au moins avoir deux fonctions acryliques ($CH_2$=CHCOO-) et peuvent être par exemple : poly(éthylène glycol) diacrylate (qui possède deux fonctions acryliques), pentaérythritol triacrylate (qui possède trois fonctions acryliques), pentaérythritol tétraacrylate (qui possède quatre fonctions acryliques). Le couplage entre les fonctions thiols et les fonctions acryliques se fait par réaction d'addition et donne lieu à une chaîne de ligand organique entourant la nanoparticule et terminée par des fonctions acrylates. La réaction d'addition peut être catalysée par des amines ou par un initiateur radicalaire.

La figure 9 illustre ce mode de réalisation dans le cas où le pentaérythritol tétrakis(3-mercaptopropionate) est utilisé comme ligand spécifique et le pentaérythritol tétraacrylate est utilisé comme monomère spécifique. Les fonctions acrylates générées à la surface de nanoparticules peuvent ensuite servir de base de réticulation pour encapsuler les boîtes quantiques dans un polymère, par exemple PMMA, ou une résine, par exemple, le silicone, ou une résine photosensible.

Une résine photosensible peut être de type époxy, acrylate, silicone ou autre, de préférence de type acrylate. Selon un mode de réalisation, la résine acrylate comprend au moins les 5 composantes suivantes :

au moins un monomère ou oligomère de base de type acrylique, ce qui forme la base de la résine ;
un liant pour améliorer les propriétés mécaniques de la résine et faciliter le développement de la résine après insolation ;
un photo-initiateur pour initier les réactions de réticulation de la résine ;
au moins un seul type de particules diffusantes pour améliorer l'efficacité de l'extraction lumineuse de la couche de boîtes quantiques/résine photosensible ;
au moins un solvant pour la mise en solution du mélange. Le solvant permet également d'ajuster la viscosité du mélange et de l'adapter aux spécifications de la méthode de mise en forme.

Le monomère ou oligomère de base de type acrylique peut être choisi dans le groupe comprenant Polyethyleneglycol diacrylate, Tripropyleneglycol diacrylate, 3 methyl-1.5-pentanediol diacrylate, Dipropyleneglycol diacrylate, Hexanediol diacrylate, Trimethylolpropane triacrylate, Trimethylolpropane, triacrylate, Trimethylolpropane triacrylate, Pentaerythritol tri et tetraacrylate, Ditrimethylolpropane tetra-acrylate, Dipentaerythritol hexaacrylate, et Dipentaerythritol hexaacrylate.

Le liant peut être un polymère ou copolymère de poids moléculaire compris entre 1000 et 40000 g/mol, de préférence entre 2000 et 20000 g/mol. Le liant doit avoir une valeur acide au moins égale à 100 mg de KOH/g de liant pour permettre une meilleure extraction de la résine lors du développement après l'insolation et aussi une meilleure adhésion de la résine au substrat cible. La composition du liant doit également prendre en compte la nature chimique des boîtes quantiques et de particules diffusantes pour assurer une meilleure compatibilité de celles-ci avec la composition photosensible. Un copolymère liant peut par exemple comprendre un monomère terminé par une fonction acide, comme l'acide acrylique, un monomère acrylate terminé par une fonction alcool comme le 2-hydroxyéthylmethacrylate et un monomère acrylate terminé par une fonction aromatique comme benzyle méthacrylate. Des monomères terminés par des fonctions vinyles ou des composés insaturés comme le styrène, méthyl vinyle éther, 4-methyle styrène, peuvent également être rajoutés au liant.

Les particules diffusantes peuvent être des particules de $SiO_2$, $Al_2O_3$, $TiO_2$, $ZrO_2$, ZnO, ou $BaSO_4$. Le diamètre de particules diffusantes peut aller de 0,005 $\mu$m à 10 pm, de préférence compris entre 0,05 $\mu$m et 1 $\mu$m.

Une large gamme de solvants (ou mélange de solvants) peut être utilisée. Les solvants peuvent être de type polaire ou apolaire en fonction du type des groupements de surface des boîtes quantiques, des particules diffusantes et de la compatibilité avec le liant, la résine, etc.

Le mélange de boîtes quantiques/composition photosensible peut être appliqué sur le substrat par différentes méthodes de dépôt, par exemple, revêtement à la tournette, enduction par trempage, pulvérisation ou enduction laminaire.

Des exemples ont été réalisés par les inventeurs. Pour les exemples comprenant une étape de broyage, comme l'étape $10_2$ décrite précédemment en relation avec la figure 8, cette étape de broyage a été réalisée en utilisant une suspension de particules photoluminescentes. Cette suspension a été réalisée en mélangeant 10 g de particules photoluminescentes dans 45 mL d'éthanol et 240 g de billes de $ZrO_2$ de 0,5 mm de diamètre. Les particules en suspension ont été broyées pendant 30 minutes et la vitesse de rotation du broyeur était de 1800 tours/min.

Pour les exemples comprenant une étape de fonctionnalisation des nanoparticules, comme l'étape 14 décrite précédemment en relation avec la figure 1, les nanoparticules fonctionnalisées ont été précipitées par ajout en excès d'acétonitrile. La phase solide a été récupérée par centrifugation, puis a été séchée entre 25 °C et 80 °C pendant 12 heures pour former une poudre de nanoparticules.

Des mesures du rendement quantique interne $QY_{int}$, du coefficient d'absorption Abs et du rendement quantique externe $QY_{ext}$ ont été réalisées sur les poudres photoluminescentes et les dispersions de particules photoluminescentes fabriquées. Le rendement quantique interne $QY_{int}$, le coefficient d'absorption Abs et le rendement quantique externe $QY_{ext}$ sont définis par les relations (4) suivantes :

$$QY_{int}=N_{em}/N_{abs}$$
$$Abs=N_{abs}/N_{exc} \quad\quad\quad (4)$$
$$QY_{ext}=QY_{int}*Abs$$

où $N_{em}$ et $N_{abs}$ sont, respectivement, le nombre de photons émis et absorbés par le matériau photoluminescent, $N_{exc}$ est le nombre de photons total émis par la source d'excitation. Les valeurs $QY_{int}$ et Abs sont directement données par l'appareil de mesure. Le rendement quantique externe $QY_{ext}$ est donc déduit de ces valeurs.

Les mesures du rendement quantique interne $QY_{int}$ et du coefficient d'absorption Abs ont été réalisées en utilisant un spectrophotomètre Hamamatsu CG-2 (250-900 nm) équipé d'une sphère d'intégration. Les valeurs de rendement quantique externe $QY_{ext}$ sont données avec une marge d'erreur de 5 %.

Dans les exemples 1 à 6 des particules photoluminescentes de YAG:$Ce^{3+}$ ont été fabriquées. De telles particules sont adaptées à émettre de la lumière jaune lorsqu'elles sont excitées par de la lumière bleue.

Exemple 1 de comparaison

La poudre de microparticules de YAG:$Ce^{3+}$ commercialisée par la société FREE RADICAL TECHNOLOGY CO., LTD (Taiwan) sous la référence PF-Y46W200 a été utilisée comme poudre de comparaison.

Ces microparticules sont obtenues par synthèse par réaction à l'état solide. Dans l'exemple 1, il n'y a pas eu réalisation d'étape de broyage et d'étape de fonctionnalisation par un agent de couplage.

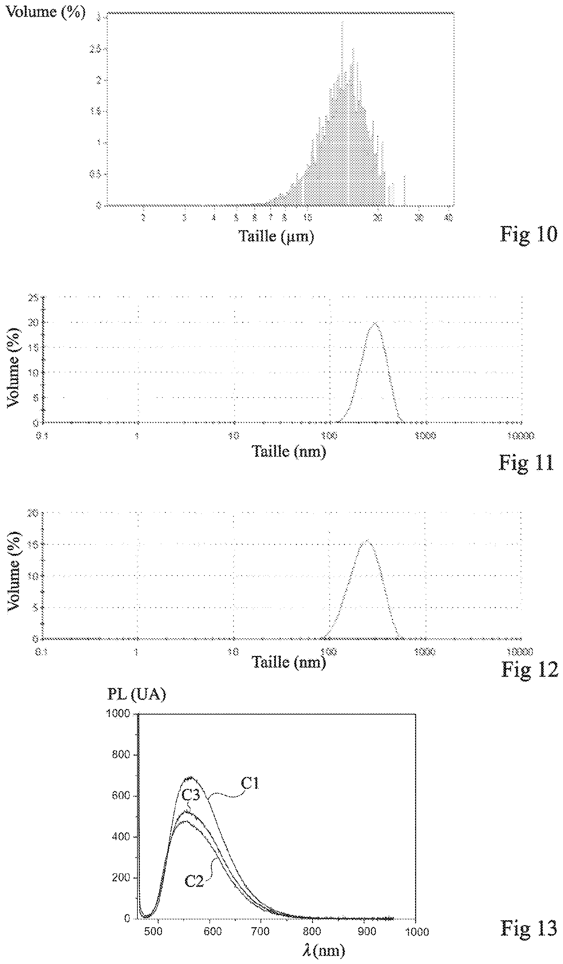

La figure 10 représente la courbe granulométrique de la poudre de microparticules de YAG:Ce$^{3+}$. Le $d_{50}$ était de 14 pm, le $d_{90}$ était de 20 $\mu$m et le $d_{10}$ était de 8 $\mu$m. Le maximum de la bande d'émission est situé à 558 nm.

Le rendement quantique interne QY$_{int}$, le coefficient d'absorption Abs et le rendement quantique externe QY$_{ext}$ ont été mesurés. Les résultats obtenus sont regroupés dans le tableau (I) ci-dessous.

**Tableau I**

| QY$_{int}$ (%) | Abs | QY$_{ext}$ (%) |
|---|---|---|
| 95 | 0,91 | 87 |

### Exemple 2 de comparaison

La poudre de microparticules de YAG:Ce$^{3+}$ de l'exemple 1 a été utilisée pour réaliser une poudre de nanoparticules.

Une étape de broyage a été réalisée. Il n'y a pas eu réalisation d'étape de fonctionnalisation par un agent de couplage.

La figure 11 représente la courbe granulométrique de la poudre de nanoparticules de YAG:Ce$^{3+}$ obtenue après broyage.

Le rendement quantique interne QY$_{int}$, le coefficient d'absorption Abs et le rendement quantique externe QY$_{ext}$ ont été mesurés. Les résultats obtenus sont regroupés dans le tableau (II) ci-dessous.

**Tableau II**

| QY$_{int}$ (%) | Abs | QY$_{ext}$ (%) |
|---|---|---|
| 68 | 0,8 | 54 |

Le rendement quantique externe QY$_{ext}$ de la poudre de nanoparticules obtenues par broyage de la poudre de l'exemple 1 sans étape de fonctionnalisation est inférieur de plus de 33 points au rendement quantique de la poudre de l'exemple 1.

### Exemple 3 de comparaison

Une poudre de nanoparticules de YAG:Ce$^{3+}$ a été fabriquée par un procédé solvothermal.

Une dispersion colloïdale de nanoparticules a été réalisée en mélangeant 56,16 mmol d'acétate d'yttrium hydraté, 0,05 mmol d'acétate de cérium (III) hydraté et 94,55 mmol d'isopropoxyde d'aluminium dans un mélange de solvants comprenant 450 mL de 1,4-butanediol et 60 mL de diéthylène glycol. Le mélange a été chauffé dans un autoclave à 300 °C pendant 1 heure. La dispersion colloïdale obtenue a été refroidie jusqu'à la température ambiante. Les nanoparticules ont été précipitées par ajout en excès d'acétonitrile. La phase solide a été récupérée par centrifugation, puis a été séchée à 80 °C pendant 12 heures pour former une poudre de nanoparticules. La poudre de nanoparticules a été recuite pendant 4 heures à 1500 °C. Avant recuit, la taille moyenne des nanoparticules était de 40 nm. Après recuit, la taille moyenne des nanoparticules était comprise entre 100 nm et 900 nm.

Le rendement quantique interne QY$_{int}$, le coefficient d'absorption Abs et le rendement quantique externe QY$_{ext}$ ont été mesurés. Les résultats obtenus sont regroupés dans le tableau (III) ci-dessous.

**Tableau III**

| QY$_{int}$ (%) | Abs | QY$_{ext}$ (%) |
|---|---|---|
| 49 | 0,71 | 35 |

### Exemple 4

La poudre de microparticules de YAG:Ce$^{3+}$ de l'exemple 1 a été utilisée pour réaliser une poudre de nanoparticules.

Une étape de broyage a été réalisée. Une étape de fonctionnalisation a été réalisée. Pour l'étape de fonctionnalisation, le solvant était l'éthanol et l'agent de couplage était le triméthoxyoctadécylsilane (TMODS, Sigma Aldrich). La concentration en nanoparticules a été ajustée à 35 mg/mL d'éthanol. Le rapport massique entre les nanoparticules et l'agent de couplage était de 1:1. La dispersion a été placée en autoclave pendant 17 heures à 150 °C et à une pression entre 20 bars et 30 bars.

La poudre de nanoparticules a été récupérée après l'étape de fonctionnalisation par l'ajout d'un excès d'éthanol (anti-solvant). L'ajout de l'éthanol entraîne une décantation très rapide des particules. Ceci est une preuve que la surface des particules est devenue hydrophobe après le traitement dans l'autoclave en présence de TMODS. Une dispersion de la poudre de nanoparticules fonctionnalisées a été réalisée dans du 1,2-dichlorobenzène qui est un solvant non polaire.

La figure 12 représente la courbe granulométrique de la dispersion de nanoparticules de YAG:Ce$^{3+}$ dans le 1,2-dichlorobenzène. Les nanoparticules fonctionnalisées sont sensiblement stables dans le solvant après plusieurs semaines à température ambiante.

Le rendement quantique interne QY$_{int}$, le coefficient d'absorption Abs et le rendement quantique externe QY$_{ext}$ ont été mesurés. Les résultats obtenus sont regroupés dans le tableau (IV) ci-dessous.

**Tableau IV**

| QY$_{int}$ (%) | Abs | QY$_{ext}$ (%) |
|---|---|---|
| 77 | 0,9 | 70 |

Le rendement quantique externe QY$_{ext}$ de la poudre de nanoparticules obtenue à l'exemple 4 est augmenté par rapport au rendement quantique externe QY$_{ext}$ de la poudre de nanoparticules obtenue aux exemples 2 et 3.

La figure 13 représente des courbes d'évolution C1, C2 et C3 de l'intensité de photoluminescence PL, en unité arbitraire, en fonction de la longueur d'onde λ, en nanomètre, du rayonnement PL émis par les poudres photoluminescentes fabriquées respectivement aux exemples 1, 2 et 4 recevant un rayonnement lumineux dont la longueur d'onde était de 460 nm. L'étape de fonctionnalisation permet d'augmenter l'intensité de photoluminescence de la poudre de nanoparticules obtenue après l'étape de broyage.

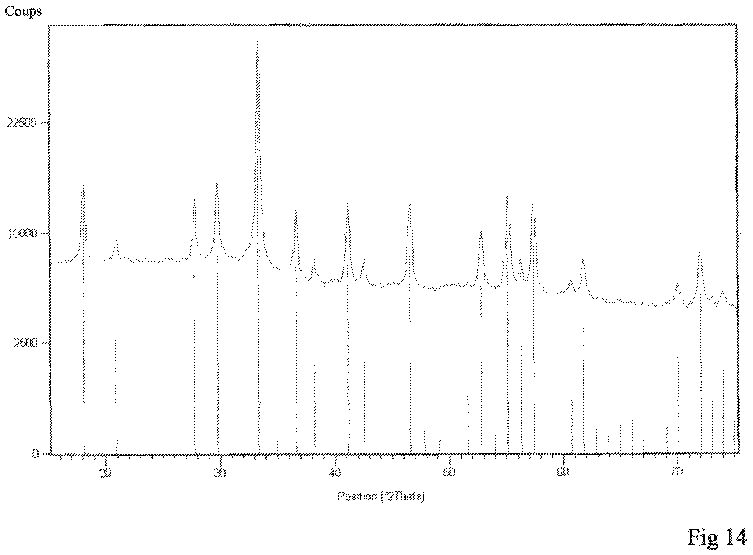

La figure 14 montre le résultat d'analyse par diffraction des rayons X réalisée sur la poudre de nanoparticules photoluminescentes séchée à l'air pendant 12 h. Le résultat montre que tous les pics de diffraction observés correspondent à la phase cristallisée de $Y_3Al_5O_{12}$. Aucune impureté ou phase parasite n'est observée. L'élargissement des pics de diffraction confirme que le diamètre des cristallites est nanométrique comme cela a été également mesuré par diffusion dynamique de la lumière et par microscopie électronique à transmission.

Exemple 5

La poudre de microparticules de YAG:Ce$^{3+}$ de l'exemple 1 a été utilisée pour réaliser une poudre de nanoparticules.

Une étape de broyage a été réalisée. Une étape de fonctionnalisation a été réalisée. Pour l'étape de fonctionnalisation, le solvant était l'éthanol et l'agent de couplage était le (3-glycidoxypropyl)triméthoxysilane (GPTMS, Sigma Aldrich). La concentration de nanoparticules a été ajustée à 50 mg/mL d'éthanol. Le rapport massique entre les nanoparticules et l'agent de couplage était de 1:1. La dispersion a été placée en autoclave pendant 25 heures à 150 °C et à une pression entre 20 bars et 30 bars.

La poudre de nanoparticules a été récupérée après l'étape de fonctionnalisation par centrifugation. Une dispersion de la poudre de nanoparticules fonctionnalisées a été réalisée dans du diéthylène glycol diéthyl éther qui est un solvant polaire.

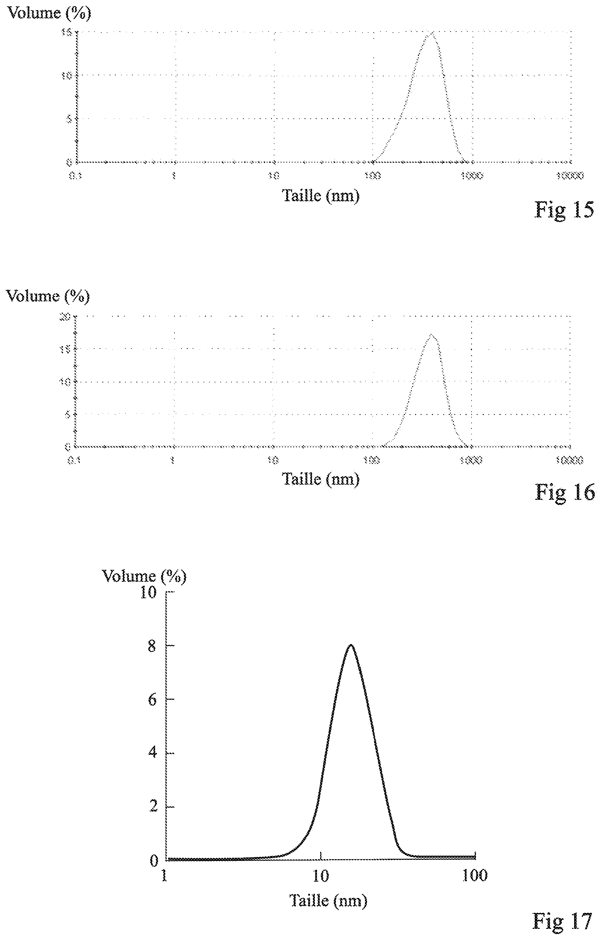

La figure 15 représente la courbe granulométrique de la poudre de nanoparticules de YAG:Ce$^{3+}$ obtenue après l'étape de fonctionnalisation. Cette courbe est proche de la courbe de la figure 11.

Le rendement quantique interne QY$_{int}$, le coefficient d'absorption Abs et le rendement quantique externe QY$_{ext}$ ont été mesurés. Les résultats obtenus sont regroupés dans le tableau (V) ci-dessous.

**Tableau V**

| QY$_{int}$ (%) | Abs | QY$_{ext}$ (%) |
|---|---|---|
| 75 | 0,8 | 60 |

Le rendement quantique externe QY$_{ext}$ de la poudre de nanoparticules obtenue à l'exemple 5 est augmenté par rapport au rendement quantique externe QY$_{ext}$ de la poudre de nanoparticules obtenue aux exemples 2 et 3.

Exemple 6

La poudre de microparticules de YAG:Ce$^{3+}$ de l'exemple 1 a été utilisée pour réaliser une poudre de nanoparticules.

Une étape de broyage a été réalisée. Une étape de prétraitement a été réalisée dans laquelle la dispersion de nanoparticules obtenues à l'étape de broyage a été mélangée à du TEOS et à une solution aqueuse à 30 % d'ammoniaque (NH₄OH). Le mélange est ensuite chauffé à 70 °C pendant 7 heures. La concentration en nanoparticules photoluminescentes a été ajustée à 18 mg/mL. Le rapport volumique entre la solution d'ammoniaque et le TEOS était de 0,5 mL de TEOS/0,4 mL de NH₄OH. La masse de $SiO_2$ après une hydrolyse/condensation complète de TEOS représente environ 5 % de la masse de nanoparticules photoluminescentes. Une étape de fonctionnalisation a été ensuite réalisée. Pour l'étape de fonctionnalisation, le solvant était l'éthanol et l'agent de couplage était le (3-triméthoxysilyl)propyl méthacrylate (TMSPMA, Sigma Aldrich). La concentration en nanoparticules photoluminescentes a été ajustée à 30 mg/mL d'éthanol. Le rapport massique entre les nanoparticules et l'agent de couplage était de 1:0,5. La dispersion a été placée en autoclave pendant 17 heures à 150 °C et à une pression comprise entre 20 bars et 30 bars.

La poudre de nanoparticules a été récupérée après l'étape de fonctionnalisation. Une dispersion de la poudre de nanoparticules fonctionnalisées a été réalisée dans du tétrahydrofurane (THF) qui est un solvant polaire. La dispersion des nanoparticules photoluminescentes reste stable (pas de décantation) dans le temps.

La figure 16 représente la courbe granulométrique de la poudre de nanoparticules de YAG:Ce³⁺ obtenue après l'étape de fonctionnalisation. Cette courbe est proche de la courbe de la figure 11.

Le rendement quantique interne $QY_{int}$, le coefficient d'absorption Abs et le rendement quantique externe $QY_{ext}$ ont été mesurés. Les résultats obtenus sont regroupés dans le tableau (VI) ci-dessous.

**Tableau VI**

| $QY_{int}$ (%) | Abs | $QY_{ext}$ (%) |
|---|---|---|
| 75 | 0,9 | 67,5 |

Le rendement quantique externe $QY_{ext}$ de la poudre de nanoparticules obtenue à l'exemple 6 est augmenté par rapport au rendement quantique externe $QY_{ext}$ de la poudre de nanoparticules obtenue aux exemples 2 et 3.

Dans les exemples 7 à 10 suivants, des particules photoluminescentes de $Lu_3Al_5O_{12}:Ce^{3+}$ (LuAG:Ce) ont été fabriquées. De telles particules sont adaptées à émettre de la lumière verte lorsqu'elles sont excitées par de la lumière bleue.

### Exemple 7 de comparaison

La poudre de microparticules de LuAG:Ce³⁺ commercialisée par la société FREE RADICAL TECHNOLOGY CO., LTD (Taiwan) sous la référence PF-X16W200 a été utilisée comme poudre de comparaison.

Ces microparticules sont obtenues par synthèse par réaction à l'état solide. Dans l'exemple 7, il n'y a pas eu réalisation d'étape de broyage et d'étape de fonctionnalisation par un agent de couplage.

La figure 17 représente la courbe granulométrique de la poudre de microparticules de LuAG:Ce³⁺. Le $d_{50}$ était de 15 μm. Le maximum du pic d'émission a été obtenu pour une longueur d'onde de 534 mm.

Le rendement quantique interne $QY_{int}$, le coefficient d'absorption Abs et le rendement quantique externe $QY_{ext}$ ont été mesurés. Les résultats obtenus sont regroupés dans le tableau (VII) ci-dessous.

**Tableau VII**

| $QY_{int}$ (%) | Abs | $QY_{ext}$ (%) |
|---|---|---|
| 95 | 0,88 | 84 |

### Exemple 8 de comparaison

La poudre de microparticules de LuAG:Ce³⁺ de l'exemple 7 a été utilisée pour réaliser une poudre de nanoparticules.

Une étape de broyage a été réalisée. Il n'y a pas eu réalisation d'étape de fonctionnalisation par un agent de couplage.

Le rendement quantique interne $QY_{int}$, le coefficient d'absorption Abs et le rendement quantique externe $QY_{ext}$ ont été mesurés. Les résultats obtenus sont regroupés dans le tableau (VIII) ci-dessous.

**Tableau VIII**

| $QY_{int}$ (%) | Abs | $QY_{ext}$ (%) |
|---|---|---|
| 78,1 | 0,702 | 54 |

Le rendement quantique externe $QY_{ext}$ de la poudre de nanoparticules obtenues par broyage de la poudre de l'exemple 8 sans étape de fonctionnalisation est inférieur de plus de 30 points au rendement quantique de la poudre de l'exemple 7.

Exemple 9

La poudre de microparticules de LuYAG:Ce$^{3+}$ de l'exemple 7 a été utilisée pour réaliser une poudre de nanoparticules.

Une étape de broyage a été réalisée. Une étape de fonctionnalisation a été réalisée. Pour l'étape de fonctionnalisation, le solvant était l'éthanol et l'agent de couplage était le triméthoxyoctadécylsilane. La concentration en nanoparticules photoluminescentes a été ajustée à 25 mg/mL d'éthanol. Le rapport massique entre les nanoparticules et l'agent de couplage était de 1:1. La dispersion a été placée en autoclave pendant 20 heures à 150 °C et à une pression comprise entre 20 bars et 30 bars.

La poudre de nanoparticules a été récupérée après l'étape de fonctionnalisation. Une dispersion de la poudre de nanoparticules fonctionnalisées a été réalisée dans du 1,2-dichlorobenzène.

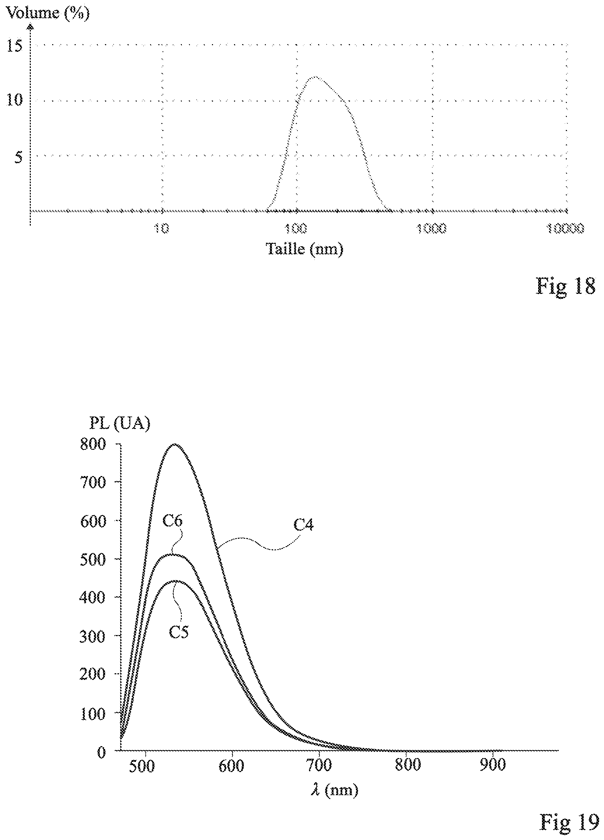

La figure 18 représente la courbe granulométrique de la dispersion de nanoparticules de LuAG:Ce$^{3+}$ dans le 1,2-dichlorobenzène obtenue après l'étape de fonctionnalisation.

Le rendement quantique interne QY$_{int}$, le coefficient d'absorption Abs et le rendement quantique externe QY$_{ext}$ ont été mesurés. Les résultats obtenus sont regroupés dans le tableau (IX) ci-dessous.

**Tableau IX**

| QY$_{int}$ (%) | Abs | QY$_{ext}$ (%) |
|---|---|---|
| 76,4 | 0,824 | 63 |

Le rendement quantique externe QY$_{ext}$ de la poudre de nanoparticules obtenue à l'exemple 10 est augmenté par rapport au rendement quantique externe QY$_{ext}$ de la poudre de nanoparticules obtenue à l'exemple 8.

La figure 19 représente les courbes C4, C5 et C6 d'évolution de l'intensité de photoluminescence PL, en unité arbitraire, en fonction de la longueur d'onde λ, en nanomètre, correspondant aux particules photoluminescentes des exemples 7, 8 et 9 sous excitation à 460 nm. L'étape de fonctionnalisation permet d'augmenter l'intensité de photoluminescence de la poudre de nanoparticules obtenue après l'étape de broyage.

Exemple 10

Dans un premier temps, des nanoparticules de YAG:Ce ont été traitées par TEOS/NH$_4$OH et fonctionnalisées par l'agent de couplage triméthoxy(7-octèn-1-yl)silane (Sigma Aldrich) selon le même mode opératoire utilisé dans l'exemple 6. Après lavage et purification, les nanoparticules photoluminescentes ont été redispersées dans le 1,2 dichlorobenzène à une concentration de 50 mg/mL. Ensuite, 30 mL de la solution de nanoparticules ont été mélangés avec 0,1 g de copolymère méthylhydro-diméthylsiloxane terminé par une fonction triméthylsilyl (hydrure de silicium, PS123, United Chemical Technologies) et 0,02 g d'une solution contenant 0,1 % massique de divinyltétraméthylsiloxane de Platine (SiP6830.3, Gelest Inc.). Le mélange est chauffé à environ 50 °C pendant 10 min. Ensuite, 0,5 g de polydiméthylsiloxane (PDMS) terminé par une fonction diméthylvinyl (PS443, United Chemical Technologies) ont été rajoutés au premier mélange et la solution finale est chauffée à 70 °C pendant 10 min à 15 min. La dispersion finale des particules est stable à température ambiante et peut être utilisée pour le dépôt de nanoparticules par impression à jet d'encre. Un film composite homogène a été réalisé à partir de la solution finale par méthode de dépôt à la tournette (spin-coating) sur une lame de verre. Le film est ensuite chauffé à 90 °C afin d'éliminer le solvant et de réticuler la résine silicone. Le pourcentage massique de nanoparticules photoluminescentes par rapport à la résine silicone dans cet exemple est égal à 70 % environ.

Exemple 11

La dispersion de nanoparticules photoluminescentes préparée à l'exemple 6 a été utilisée. La concentration en nanoparticules photoluminescentes a été ajustée à 20 mg/mL de THF. 50 mL de la solution de nanoparticules photoluminescentes sont mélangés avec 0,9 mL de méthyl méthacrylate (MMA, Sigma Aldrich) sous agitation magnétique. En parallèle, une solution de 2,2'-azobis(2-méthylpropionitrile) (AIBN), initiateur de polymérisation radicalaire, (Sigma Aldrich) a été préparée par la dissolution de 50 mg d'AIBN dans 5 ml de THF. La solution d'AIBN a été rajoutée au mélange contenant les nanoparticules photoluminescentes et le mélange final est chauffé à 70 °C pendant 4 h. Une dispersion de nanoparticules photoluminescentes/PMMA est obtenue et peut être utilisée pour le dépôt de particules photoluminescentes, par exemple, par impression à jet d'encre. Le pourcentage massique de nanoparticules photoluminescentes par rapport au PMMA est égal à environ 60 %.

Dans les exemples 12 à 14 des particules photoluminescentes de $(La,Y)_3Si_6N_{11}$:Ce ont été fabriquées. De telles particules sont adaptées à émettre de la lumière jaune lorsqu'elles sont excitées par de la lumière bleue.

Exemple 12 de comparaison

La poudre de microparticules de $(La,Y)_3Si_6N_{11}$:Ce commercialisée par la société Mitsubishi Chemical Corporation (Japon) sous la référence BY-202/A a été utilisée comme poudre de comparaison.

Ces microparticules sont obtenues par synthèse par réaction à l'état solide. Dans l'exemple 12, il n'y a pas eu réalisation d'étape de broyage et d'étape de fonctionnalisation par un agent de surface.

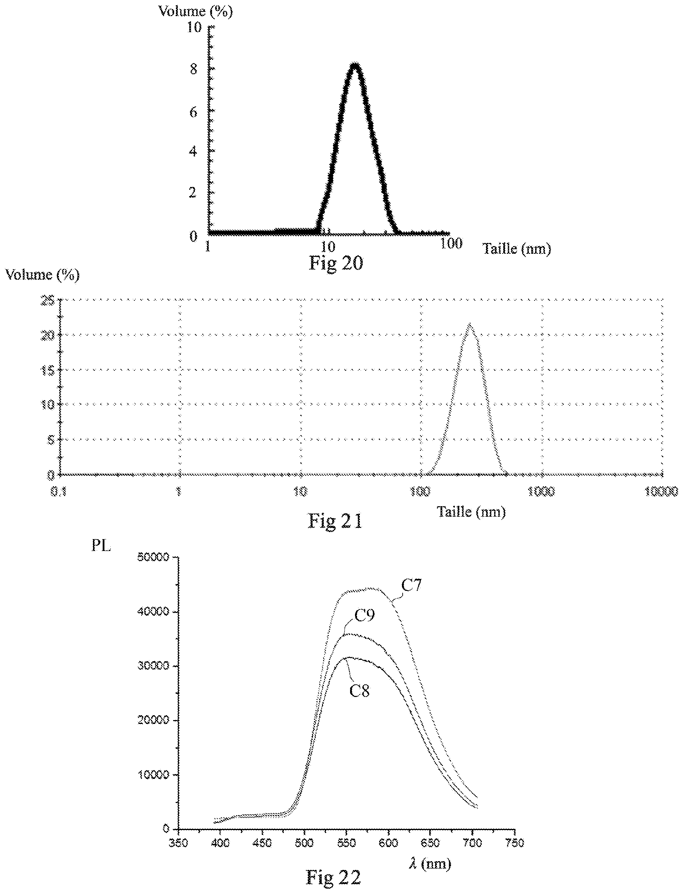

La figure 20 représente la courbe granulométrique de la poudre de microparticules, le d50 était de 15 $\mu$m. Le maximum de la bande d'émission est situé à 547 nm.

Le rendement quantique interne $QY_{int}$, le coefficient d'absorption Abs et le rendement quantique externe $QY_{ext}$ ont été mesurés. Les résultats obtenus sont regroupés dans le tableau (X) ci-dessous.

**Tableau X**

| $QY_{int}$ (%) | Abs | $QY_{ext}$ (%) |
|---|---|---|
| 80 | 0,9 | 72 |

Exemple 13 de comparaison

La poudre de microparticules de $(La,Y)_3Si_6N_{11}$:Ce de l'exemple 12 a été utilisée pour réaliser une poudre de nanoparticules. Une étape de broyage a été réalisée. Il n'y a pas eu réalisation d'étape de fonctionnalisation par un agent de surface.

Le rendement quantique interne $QY_{int}$, le coefficient d'absorption Abs et le rendement quantique externe $QY_{ext}$ ont été mesurés. Les résultats obtenus sont regroupés dans le tableau (XI) ci-dessous.

**Tableau XI**

| $QY_{int}$ (%) | Abs | $QY_{ext}$ (%) |
|---|---|---|
| 55 | 0,7 | 38,5 |

Le rendement quantique externe $QY_{ext}$ de la poudre de nanoparticules obtenues par broyage de la poudre de l'exemple 12 sans étape de modification de surface est inférieur de plus de 33 points au rendement quantique de la poudre de l'exemple 12.

Exemple 14

La poudre de microparticules de $(La,Y)_3Si_6N_{11}$:Ce de l'exemple 12 a été utilisée pour réaliser une poudre de nanoparticules.

Une étape de broyage a été réalisée. Une étape de fonctionnalisation a été réalisée. Il est connu dans l'état de l'art que les matériaux à base de nitrure de silicium ont des propriétés de surface proches de celles des matériaux silicates. La surface de particules nanométriques de $(La,Y)_3Si_6N_{11}$:Ce peut donc disposer de groupements Si-OH qui peuvent être utilisés pour greffer des agents de couplage de type silane, par exemple. Pour l'étape de fonctionnalisation, le solvant était l'éthanol et l'agent de couplage était le 2-[Méthoxy(Polyéthylèneoxy)6-9Propryl]Triméthoxysilane commercialisé sous la référence SiM6492.7 par la société Gelest, Inc. La concentration en nanoparticules a été ajustée à 20 mg/mL d'éthanol. Le rapport massique entre les nanoparticules et l'agent de couplage était de 1:2,5. La dispersion a été placée en autoclave pendant 17 heures à 150 °C et à une pression entre 20 bars (2 MPa) et 30 bars (3 MPa).

Après le traitement dans l'autoclave, un échange de solvant éthanol par le solvant éthyle diglyme a été réalisé. La figure 21 représente la courbe granulométrique de la suspension de nanoparticules de $(La,Y)_3Si_6N_{11}$:Ce dans le solvant éthyle diglyme. La taille moyenne des particules est de 256 nm. Les nanoparticules fonctionnalisées sont sensiblement stables dans le solvant après plusieurs semaines à température ambiante.

Le rendement quantique interne QYint, le coefficient d'absorption Abs et le rendement quantique externe QYext des particules nanométriques de $(La,Y)_3Si_6N_{11}$:Ce dans le solvant éthyle diglyme ont été mesurés. Les résultats obtenus sont regroupés dans le tableau (XII) ci-dessous.

**Tableau XII**

| QY$_{int}$ (%) | Abs | QY$_{ext}$ (%) |
|---|---|---|
| 70 | 0,9 | 63 |

Le rendement quantique externe QY$_{ext}$ de la poudre de nanoparticules obtenue à l'exemple 14 est augmenté par rapport au rendement quantique externe QY$_{ext}$ de la poudre de nanoparticules obtenue à l'exemple 13.

La figure 22 représente des courbes d'évolution C7, C8 et C9 de l'intensité de photoluminescence PL, en fonction de la longueur d'onde $\lambda$, en nanomètre, émise par les particules photoluminescentes fabriquées respectivement aux exemples 12, 13 et 14 recevant un rayonnement lumineux dont la longueur d'onde était de 460 nm. L'étape de modification de surface permet d'augmenter l'intensité de photoluminescence de la poudre de nanoparticules obtenue après l'étape de broyage.

Une suspension stable de particules nanométriques de $(La,Y)_3Si_6N_{11}$:Ce dans le solvant éthyle diglyme a été obtenue. La suspension de particules préparée ainsi peut être mélangée avec un polymère de type acrylate, par exemple PMMA, pour former une encre de luminophore stable et prête à l'emploi, par exemple, en impression numérique à jet d'encre. D'autres méthodes de dépôt peuvent également être utilisées, notamment, l'impression par jet d'aérosol. La viscosité du mélange nanoparticules $(La,Y)_3Si_6N_{11}$:Ce /PMMA peut être ajustée entre 2 Cps (2 mPa.s) et 100 Cps (100 mPa.s), de préférence entre 4 Cps (4 mPa.s) et 20 Cps (20 mPa.s).

Dans les exemples 15 à 18, des particules photoluminescentes de $CaAlSiN_3$:Eu ont été fabriquées. De telles particules sont adaptées à émettre de la lumière rouge lorsqu'elles sont excitées par de la lumière bleue.

Exemple 15 de comparaison

La poudre de microparticules de $CaAlSiN_3$:Eu commercialisée par la société Mitsubishi Chemical Corporation (Japon) sous la référence BR-101/J a été utilisée comme poudre de comparaison.

Ces microparticules sont obtenues par synthèse par réaction à l'état solide. Dans l'exemple 15, il n'y a pas eu réalisation d'étape de broyage et d'étape de fonctionnalisation par un agent de surface.

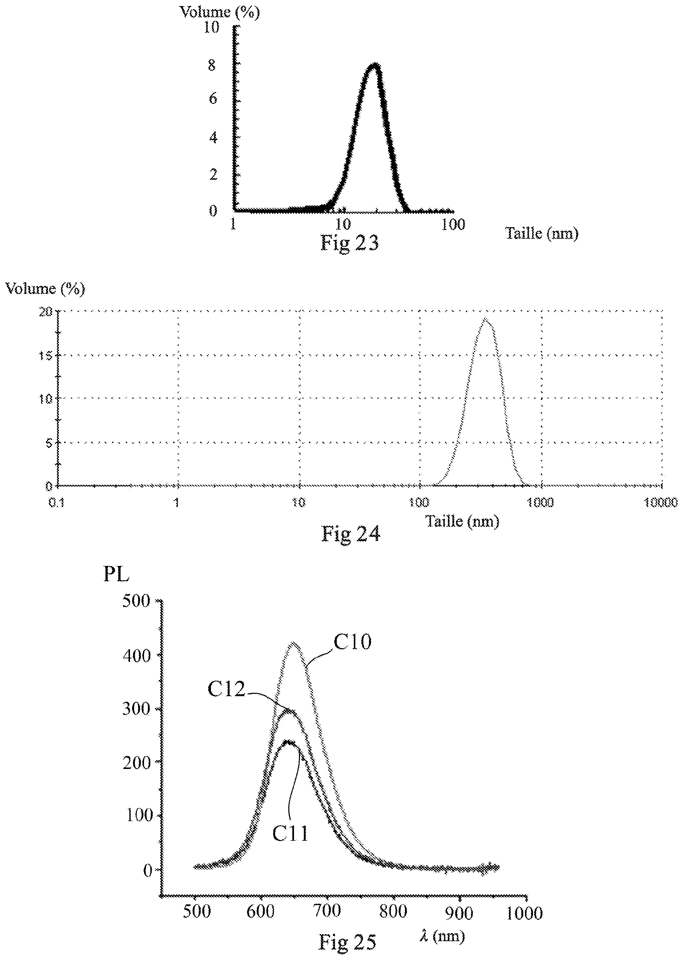

La figure 23 représente la courbe granulométrique de la poudre de microparticules, le d50 était de 16 $\mu$m. Le maximum de la bande d'émission est situé à 648 nm.

Le rendement quantique interne QY$_{int}$, le coefficient d'absorption Abs et le rendement quantique externe QY$_{ext}$ ont été mesurés. Les résultats obtenus sont regroupés dans le tableau (XIII) ci-dessous.

**Tableau XIII**

| QY$_{int}$ (%) | Abs | QY$_{ext}$ (%) |
|---|---|---|
| 92 | 0,84 | 77 |

Exemple 16 de comparaison

La poudre de microparticules de $CaAlSiN_3$:Eu de l'exemple 15 a été utilisée pour réaliser une poudre de nanoparticules. Une étape de broyage a été réalisée. Il n'y a pas eu réalisation d'étape de fonctionnalisation par un agent de couplage.

Le rendement quantique interne QY$_{int}$, le coefficient d'absorption Abs et le rendement quantique externe QY$_{ext}$ ont été mesurés. Les résultats obtenus sont regroupés dans le tableau (XIV) ci-dessous.

**Tableau XIV**

| QY$_{int}$ (%) | Abs | QY$_{ext}$ (%) |
|---|---|---|
| 50 | 0,69 | 34,5 |

Le rendement quantique externe QY$_{ext}$ de la poudre de nanoparticules obtenues par broyage de la poudre de l'exemple 15 sans étape de modification de surface est inférieur de plus de 42 points au rendement quantique de la poudre de l'exemple 15.

Exemple 17

La poudre de microparticules de $CaAlSiN_3$:Eu de l'exemple 15 a été utilisée pour réaliser une poudre de nanoparticules.

Une étape de broyage a été réalisée. Une étape de fonctionnalisation a été réalisée. Pour l'étape de fonctionnalisation, le solvant était l'éthanol et l'agent de couplage était l'allyltrimethoxysilane, commercialisé sous la référence SiA0540.0 par la société Gelest, Inc. La concentration en nanoparticules a été ajustée à 15 mg/mL d'éthanol. Le rapport massique entre les nanoparticules et l'agent de couplage était de 1:2. La dispersion a été placée en autoclave pendant 24 heures à 170 °C et à une pression entre 20 bars et 30 bars.

La poudre de nanoparticules a été récupérée après l'étape de fonctionnalisation par l'ajout d'un excès d'éthanol (anti-solvant). L'ajout de l'éthanol entraîne une décantation très rapide des particules. Ceci est une preuve que la surface des particules est devenue hydrophobe après le traitement dans l'autoclave en présence de l'allyltrimethoxysilane. Une dispersion de la poudre de nanoparticules fonctionnalisées a été réalisée dans du 1,2-dichlorobenzène.

La figure 24 représente la courbe granulométrique de la dispersion de nanoparticules de $CaAlSiN_3$:Eu dans le solvant 1,2-dichlorobenzène. La taille moyenne de particules était de 350 nm. Les nanoparticules fonctionnalisées sont sensiblement stables dans le solvant après plusieurs jours à température ambiante.

Le rendement quantique interne $QY_{int}$, le coefficient d'absorption Abs et le rendement quantique externe $QY_{ext}$ des particules nanométriques de $CaAlSiN_3$:Eu dans le solvant 1,2-dichlorobenzène ont été mesurés. Les résultats obtenus sont regroupés dans le tableau (XV) ci-dessous.

**Tableau XV**

| $QY_{int}$ (%) | Abs | $QY_{ext}$ (%) |
|---|---|---|
| 75 | 0,8 | 60 |

Le rendement quantique externe $QY_{ext}$ de la suspension de nanoparticules obtenue à l'exemple 17 est augmenté par rapport au rendement quantique externe $QY_{ext}$ de la suspension de nanoparticules obtenue à l'exemple 16.

La figure 25 représente des courbes d'évolution C10, C11 et C12 de l'intensité de photoluminescence PL, en fonction de la longueur d'onde $\lambda$, en nanomètre, émise par les particules photoluminescentes fabriquées respectivement aux exemples 15, 16 et 17 recevant un rayonnement lumineux dont la longueur d'onde était de 460 nm. L'étape de modification de surface permet d'augmenter l'intensité de photoluminescence de la poudre de nanoparticules obtenue après l'étape de broyage.

Exemple 18

Une encre à base de $CaAlSiN_3$:Eu/silicone a été préparée. Dans ce but, 2,35 g de particules nanométriques de $CaAlSiN_3$:Eu obtenues dans l'exemple 17 ont été dispersés dans 20 mL de solvant 1,2-dichlorobenzène. Ensuite 2,1 g d'un polydiméthyle siloxane (PDMS) terminé par deux fonctions hydrures, commercialisé sous la référence DMS-H21 par la société Gelest, Inc, et 0,05 g d'un catalyseur à base de Pt, commercialisé sous la référence SiP6832.2 par la société Gelest, Inc, ont été rajoutés à la suspension de particules nanométriques de $CaAlSiN_3$:Eu. Le mélange est ensuite chauffé à 90 °C pendant 12 h. Apres refroidissement, 0,25 g de PDMS terminé par deux fonctions vinyles, commercialisé sous la référence DMS-V31 par la société Gelest, Inc, ont été rajoutés au mélange qui est ensuite chauffé à 90 °C pendant 30 min. Une encre stable de luminophore $CaAlSiN_3$:Eu à base de silicone est ainsi obtenue et prête à l'emploi, par exemple, en impression à jet d'encre.

Dans les exemples 19 à 21 des particules photoluminescentes de $K_2SiF_6$:Mn ont été fabriquées. De telles particules sont adaptées à émettre de la lumière rouge lorsqu'elles sont excitées par de la lumière bleue.

Exemple 19 de comparaison

La poudre de microparticules de $K_2SiF_6$:Mn commercialisée par la société Mitsubishi Chemical Corporation (Japon) sous la référence BR-301/C a été utilisée comme poudre de comparaison.

Ces microparticules sont obtenues par synthèse par réaction à l'état solide. Dans l'exemple 19, il n'y a pas eu réalisation d'étape de broyage et d'étape de fonctionnalisation par un agent de surface.

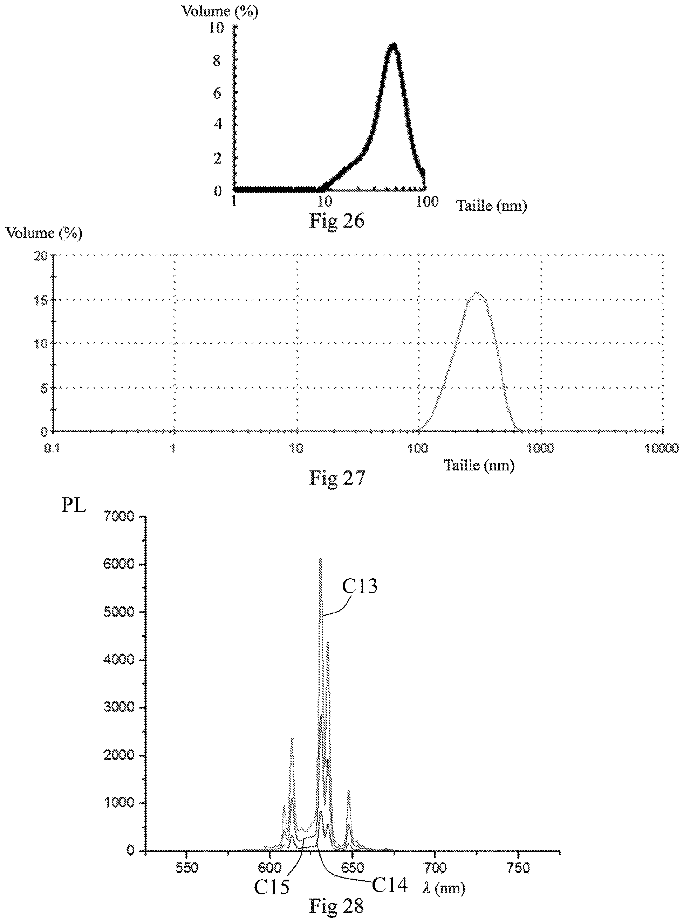

La figure 26 représente la courbe granulométrique de la poudre de microparticules, le d50 était de 42 $\mu$m. Le maximum de la bande d'émission est situé à 632 nm.

Le rendement quantique interne $QY_{int}$, le coefficient d'absorption Abs et le rendement quantique externe $QY_{ext}$ ont été mesurés. Les résultats obtenus sont regroupés dans le tableau (XVI) ci-dessous.

**Tableau XVI**

| $QY_{int}$ (%) | Abs | $QY_{ext}$ (%) |
|---|---|---|
| 91 | 0,72 | 65,5 |

Exemple 20 de comparaison

La poudre de microparticules de $K_2SiF_6$:Mn de l'exemple 19 a été utilisée pour réaliser une poudre de nanoparticules. Une étape de broyage a été réalisée. Il n'y a pas eu réalisation d'étape de fonctionnalisation par un agent de couplage.

Le rendement quantique interne $QY_{int}$, le coefficient d'absorption Abs et le rendement quantique externe $QY_{ext}$ ont été mesurés. Les résultats obtenus sont regroupés dans le tableau (XVII) ci-dessous.

**Tableau XVII**

| $QY_{int}$ (%) | Abs | $QY_{ext}$ (%) |
|---|---|---|
| 35 | 0,72 | 25 |

Le rendement quantique externe $QY_{ext}$ de la poudre de nanoparticules obtenues par broyage de la poudre de l'exemple 20 sans étape de modification de surface est inférieur de plus de 40 points au rendement quantique de la poudre de l'exemple 19.

Exemple 21

La poudre de microparticules de $K_2SiF_6$:Mn de l'exemple 19 a été utilisée pour réaliser une poudre de nanoparticules.

Une étape de broyage a été réalisée. Une étape de fonctionnalisation a été réalisée. L'étape de fonctionnalisation est précédée par un traitement de surface visant à réparer les défauts ou une partie des défauts de surface générés par le broyage. Typiquement, 20 mg d'hydrogénofluorure de potassium $KHF_2$ commercialisé par la société Sigma Aldrich et 5 mg de particules de silice nanométrique $SiO_2$ (de taille moyenne de 12 nm commercialisées par la société Sigma Aldrich) ont été rajoutés à 200 mL de la suspension de nanoparticules $K_2SiF_6$:Mn de l'exemple 20, la concentration en particules de $K_2SiF_6$:Mn a été ajustée à 10 mg/mL d'éthanol. Le mélange est ensuite transféré en autoclave et chauffé à 170 °C pendant 24 h. Ensuite, 140 µL d'acide oléique sont rajoutés au mélange qui est chauffé à nouveau dans l'autoclave pendant 2 h à 110 °C à une pression entre 20 bars et 30 bars.

La poudre de nanoparticules a été récupérée après l'étape de fonctionnalisation par centrifugation. Une dispersion de la poudre de nanoparticules fonctionnalisées a été réalisée dans du 1,2-dichlorobenzène.

La figure 27 représente la courbe granulométrique de la suspension de nanoparticules de $K_2SiF_6$:Mn dans le solvant 1,2-dichlorobenzène. La taille moyenne des particules était de 295 nm. Les nanoparticules fonctionnalisées sont sensiblement stables dans le solvant après plusieurs jours à température ambiante.

Le rendement quantique interne $QY_{int}$, le coefficient d'absorption Abs et le rendement quantique externe $QY_{ext}$ des particules nanométriques de $K_2SiF_6$:Mn dans le solvant 1,2-dichlorobenzène ont été mesurés. Les résultats obtenus sont regroupés dans le tableau (XVIII) ci-dessous.

**Tableau XVIII**

| $QY_{int}$ (%) | Abs | $QY_{ext}$ (%) |
|---|---|---|
| 73 | 0,8 | 58,4 |

Le rendement quantique externe $QY_{ext}$ de la suspension de nanoparticules obtenue à l'exemple 21 est sensiblement augmenté par rapport au rendement quantique externe $QY_{ext}$ de la suspension de nanoparticules obtenue à l'exemple 20.

La figure 28 représente des courbes d'évolution C13, C14 et C15 de l'intensité de photoluminescence PL, en fonction de la longueur d'onde λ, en nanomètre, émise par les particules photoluminescentes fabriquées respectivement aux exemples 1, 2 et 3 recevant un rayonnement lumineux dont la longueur d'onde était de 460 nm. L'étape de modification de surface et de fonctionnalisation permet d'augmenter l'intensité de photoluminescence de la poudre de nanoparticules obtenue après l'étape de broyage.

Exemple 22

Une suspension de boîtes quantiques de type CdSe/ZnS dans le solvant toluène et commercialisée par la société Najing Technology (Chine) a été utilisée comme solution de comparaison. Les boîtes quantiques sont stabilisées par le ligand acide oléique.

Ces nanocristaux de semiconducteur sont obtenus par synthèse par réactions en solution. Dans l'exemple 22, il n'y a pas eu de modification de surface de particules.

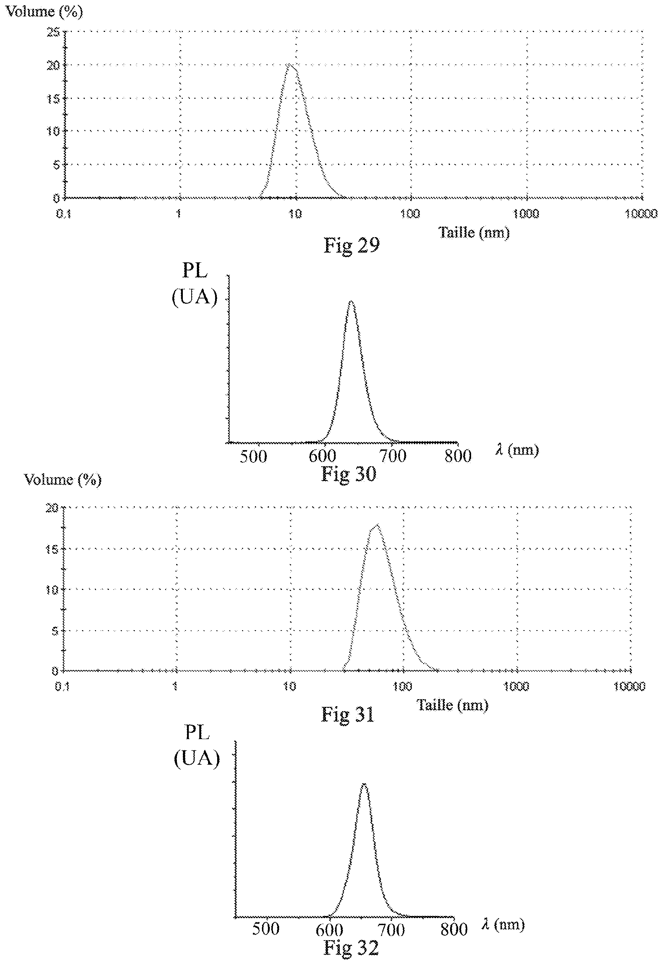

La figure 29 représente la courbe de distribution de taille de nanocristaux dans le toluène. Nous précisons que les tailles mesurées représentent le rayon hydrodynamique et non pas le rayon de la particule dure. Le rayon hydrodynamique correspond en effet au rayon de la sphère dure plus une épaisseur de la couche de solvatation formée autour de la particule. La couche de solvatation contient à la fois le ligand et le solvant. Le rayon hydrodynamique moyen était 10 nm environ. Le maximum de la bande d'émission est situé à 640 nm. La figure 30 montre l'intensité de photoluminescence PL, en fonction de la longueur d'onde $\lambda$, en nanomètre, émise par les boîtes quantiques de l'exemple 22 recevant un rayonnement lumineux dont la longueur d'onde était de 460 nm.

Le rendement quantique interne $QY_{int}$, le coefficient d'absorption Abs et le rendement quantique externe $QY_{ext}$ ont été mesurés. Les résultats obtenus sont regroupés dans le tableau (XIX) ci-dessous.

**Tableau XIX**

| $QY_{int}$ (%) | Abs | $QY_{ext}$ (%) |
|---|---|---|
| 80 | 0,98 | 78,5 |

Exemple 23

La solution de boîtes quantiques de l'exemple 22 a été utilisée pour réaliser l'étape de fonctionnalisation de surface dans l'autoclave. La fonctionnalisation de surface s'est déroulée en deux étapes. Dans un premier temps, une fonctionnalisation de surface de boîtes quantiques par l'agent de couplage 3-mercaptopropyltrimethoxysilane est réalisée. Par exemple, 200 mL de solution de boîtes quantiques à une concentration de 1 mg/mL est préparée et transférée dans un autoclave de 200 mL de volume. La solution de boîtes quantiques est dégazée en oxygène en faisant buller la solution avec de l'azote N2 jusqu'à saturation. La solution de boîtes quantiques est ensuite placée en boite à gants et 170 mg d'agent de couplage 3-mercaptopropyltrimethoxysilane sont rajoutés à la solution de boîtes quantiques. L'autoclave est ensuite rigoureusement fermé, sorti de la boite à gants et chauffé à 170 °C sous agitation pendant 12 h. Les boîtes quantiques sont ensuite récupérées par centrifugation et lavées ensuite avec un excès d'éthanol. Le traitement dans l'autoclave en présence d'agent de couplage 3-mercaptopropyltrimethoxysilane est répété jusqu'à ce que les boîtes quantiques forment une suspension stable dans l'éthanol. En seconde étape, les boîtes quantiques issues de la première étape ont été dispersées dans 200 mL d'éthanol anhydre et transféré en autoclave. Un bullage à l'azote $N_2$ jusqu'à saturation a également été réalisé. L'autoclave est placé en boite à gants et 250 mg d'agent de couplage (3-triméthoxysilyl)propyl méthacrylate sont rajoutés à la solution de boîtes quantiques. L'autoclave est sorti de la boite à gants et chauffé à 170 °C sous agitation pendant 12 h. Un échange de solvant éthanol par le solvant Propylene glycol monomethyl ether acetate (PGMEA) a été réalisé. Des boîtes quantiques fonctionnalisées par des groupements méthacryliques sont donc obtenues.

La figure 31 représente la courbe de distribution de taille de nanocristaux dans le solvant PGMEA. Le rayon hydrodynamique moyen était de 66 nm environ. Le rayon hydrodynamique moyen est augmenté par rapport aux boîtes quantiques de l'exemple 22.

La figure 32 montre l'intensité de photoluminescence PL, en fonction de la longueur d'onde $\lambda$, en nanomètre, émise par les boîtes quantiques de l'exemple 23 recevant un rayonnement lumineux dont la longueur d'onde était de 460 nm. Le maximum de la bande d'émission est situé à 655 nm.

Le rendement quantique interne $QY_{int}$, le coefficient d'absorption Abs et le rendement quantique externe $QY_{ext}$ ont été mesurés. Les résultats obtenus sont regroupés dans le tableau (XX) ci-dessous.

**Tableau XX**

| $QY_{int}$ (%) | Abs | $QY_{ext}$ (%) |
|---|---|---|
| 70 | 0,98 | 68,6 |

Exemple 24

Un mélange boîtes quantiques/composition photosensible a été réalisé.

La solution de boîtes quantiques de l'exemple 23 a été utilisée pour réaliser le mélange boîtes quantiques/composition photosensible. Le tableau (XXI) montre un exemple de formulation avec les pourcentages massiques et les constituants de chaque composant.

**Tableau XXI**

| Composant | % massique | constituants |
|---|---|---|
| Solvant | 60 | PGMEA |
| Monomère + initiateur | 15 | Dipentaerythritol penta- /hexa-acrylate (7,4 %) (IGM) + Di (trimethylolpropane) tetraacrylate (7,4 %) (sigma Aldrich) + 2,2'-Azobis(2-methylpropionitrile) (0,2 %) (Sigma Aldrich) |
| Liant | 10 | Copolymère ternaire (benzyle méthacrylate/acide méthacrylique/2-hydroxyéthylmethacrylate), rapport molaire 54/36/10. Valeur acide = 152 mg de KOH/g. poids moléculaire = 19900 g/mol. |
| Particules diffusantes | 5 | Nanoparticules de $TiO_2$ (<250 nm, sigma aldrich) |
| Quantum dots | 10 | Boîtes quantiques de l'exemple 23. |

Le liant de l'exemple 23 peut être fabriqué par exemple suivant le protocole décrit dans la référence : Journal of Applied Polymer Science, Vol. 109, 467-474 (2008). Le mélange de boîtes quantiques avec la composition photosensible du tableau (XXI) est réalisé à l'abri de la lumière du jour sous agitation constante de 300 tours par minute. Le mélange peut également être réalisé à l'aide d'un mélangeur planétaire. Grâce à ces fonctions méthacrylates de surface, les boîtes quantiques avaient une très bonne affinité avec la composition photosensible. Par conséquent, les boîtes quantiques de l'exemple 23 formaient une suspension stable dans le mélange photosensible. Par ailleurs, les fonctions méthacrylate réticulables situées à la surface des boîtes quantiques permettaient une meilleure dispersion des boîtes quantiques dans la résine après réticulation sous UV.

Les exemples précédents montrent que le rendement quantique externe $QY_{ext}$ de la suspension de nanoparticules est sensiblement augmenté quelle que soit la nature chimique des nanoparticules photoluminescentes en mettant en oeuvre un traitement de surface avec un agent de surface adapté.

## Revendications

1. Procédé de fabrication de nanoparticules d'un matériau photoluminescent, comprenant les étapes successives suivantes :

   a) former des particules nanométriques (32) dudit matériau photoluminescent ;
   b) réaliser une dispersion contenant les particules dans un solvant non aqueux, la dispersion contenant, en outre, au moins un agent de surface ;
   c) placer la dispersion dans un autoclave à une pression comprise entre 2 MPa et 100 MPa ; et
   d) récupérer les particules.

2. Procédé selon la revendication 1, dans lequel l'étape b) est précédée d'un traitement de surface des particules nanométriques (32) par un précurseur de silice.

3. Procédé selon la revendication 1 ou 2, dans lequel l'agent de surface est un composé organo-fonctionnel ayant la formule chimique suivante :

$$R_nSiX_{4-n}$$

où n est égal à 1, 2 ou 3, X désigne un groupement hydrolysable, et R est un groupement organique non hydrolysable.

4. Procédé selon la revendication 3, dans lequel X est un groupement alcoxy, un groupement halogénure ou un groupement amine.

5. Procédé selon la revendication 1 ou 2, dans lequel l'agent de surface est un composé ayant la formule chimique suivante :

R-Y-R'

où Y est une chaîne hydrocarbure contenant éventuellement en outre au moins un atome d'oxygène, et R et R' sont des groupes chimiques de type thiol (-SH), acide carboxylique (-COOH), alcool (-OH), amine (-NH2), acrylate, ou un groupement fonctionnel non réactif.

6. Procédé selon l'une quelconque des revendications 1 à 5, dans lequel le solvant non aqueux est un alcool.

7. Procédé selon l'une quelconque des revendications 1 à 6, dans lequel l'étape a) comprend le broyage de particules dudit matériau photoluminescent dont la taille moyenne est supérieure à 1 $\mu$m pour obtenir les particules nanométriques (32).

8. Procédé selon la revendication 7, dans lequel les particules dudit matériau photoluminescent dont la taille moyenne est supérieure à 1 $\mu$m sont broyées en milieu humide.

9. Procédé selon la revendication 7, dans lequel les particules dudit matériau photoluminescent dont la taille moyenne est supérieure à 1 $\mu$m sont broyées dans un solvant différent du solvant non aqueux utilisé à l'étape b).

10. Procédé selon l'une quelconque des revendications 1 à 9, dans lequel la durée de l'étape c) est comprise entre 30 minutes et 48 heures.

11. Procédé selon l'une quelconque des revendications 1 à 9, dans lequel la température dans l'autoclave est comprise entre 25 °C et 300 °C.

12. Procédé selon l'une quelconque des revendications 1 à 11, dans lequel le matériau photoluminescent est un aluminate, un silicate, un nitrure, un oxynitrure, un fluorure ou un sulfure.

13. Procédé selon la revendication 12, dans lequel le matériau photoluminescent comprend majoritairement un oxyde d'yttrium et d'aluminium ou un oxyde de lutécium et d'aluminium contenant, en outre, au moins un des éléments suivants : cérium, europium, chrome, néodyme, terbium, dysprosium, praséodyme ou gadolinium.

14. Procédé selon l'une quelconque des revendications 1 à 13, comprenant, en outre, avant l'étape c), une étape de mélange et de traitement dans l'autoclave des particules nanométriques en présence de la totalité ou d'une partie des précurseurs utilisés pour former les particules nanométriques.

15. Procédé selon l'une quelconque des revendications 1 à 14, comprenant, en outre, avant l'étape c), une étape de mélange des particules nanométriques avec au moins une substance photoluminescente (36 ; 37).

16. Procédé selon la revendication 15, dans lequel la substance photoluminescente est une boîte quantique (37).

17. Procédé selon l'une quelconque des revendications 1 à 16, dans lequel les particules nanométriques (32) sont des boîtes quantiques.

18. Procédé selon l'une quelconque des revendications 1 à 17, comprenant la formation d'un mélange stable des particules nanométriques avec une composition de résine photosensible.

19. Procédé selon la revendication 18, dans lequel la résine photosensible est de type acrylate.

20. Procédé selon la revendication 18 ou 19, dans lequel la composition de résine photosensible comprend, en outre, au moins un élément choisi parmi un liant, un solvant, un photo-initiateur ou des particules diffusantes.

**Patentansprüche**

1. Verfahren zur Herstellung von Nanopartikeln eines photolumineszenten Materials, das die folgenden aufeinanderfolgenden Schritte aufweist:

a) Ausbilden von Partikeln (32) im Nanometerbereich des photolumineszenten Materials;

b) Ausbilden einer Dispersion, die die Partikel in einem nicht-wässrigen Lösungsmittel enthält, wobei die Dispersion außerdem mindestens eine oberflächenaktive Agens enthält;

c) Platzieren der Dispersion in einen Autoklaven bei einem Druck im Bereich von 2 MPa bis 100 MPa; und

d) Rückgewinnung der Partikel.

2. Verfahren nach Anspruch 1, wobei dem Schritt b) eine Oberflächenbehandlung der Partikel (32) im Nanometerbereich durch einen Siliciumdioxid-Vorläufer vorausgeht.

3. Verfahren nach Anspruch 1 oder 2, wobei die oberflächenaktive Agens eine organofunktionelle Verbindung mit der folgenden chemischen Formel ist:

$$R_nSiX_{4-n}$$

wobei n gleich 1, 2 oder 3 ist, X eine hydrolysierbare Gruppe bezeichnet und R eine nicht-hydrolysierbare organische Gruppe ist.

4. Verfahren nach Anspruch 3, wobei X eine Alkoxygruppe, eine Halogenidgruppe oder eine Amingruppe ist.

5. Verfahren nach Anspruch 1 oder 2, wobei die oberflächenaktive Agens eine Verbindung mit der folgenden chemischen Formel ist:

$$R-Y-R'$$

wobei Y eine Kohlenwasserstoffkette ist, die möglicherweise zusätzlich mindestens ein Sauerstoffatom enthält, und R und R' chemische Gruppen vom Thiol- (-SH), Carbonsäure- (-COOH), Alkohol- (-OH), Amin- (-NH2), Acrylat-Typ oder eine nicht reaktive funktionelle Gruppe sind.

6. Verfahren nach einem der Ansprüche 1 bis 5, wobei das nichtwässrige Lösungsmittel ein Alkohol ist.

7. Verfahren nach einem der Ansprüche 1 bis 6, wobei Schritt a) das Mahlen von Teilchen des photolumineszenten Materials mit einer durchschnittlichen Größe von mehr als 1 $\mu$m aufweist, um die Partikel (32) im Nanometerbereich zu erhalten.

8. Verfahren nach Anspruch 7, wobei die Partikel des photolumineszenten Materials mit einer durchschnittlichen Größe von mehr als 1 $\mu$m in einer nassen Umgebung gemahlen werden.

9. Verfahren nach Anspruch 7, wobei die Partikel des photolumineszenten Materials mit einer durchschnittlichen Größe von mehr als 1 $\mu$m in einem Lösungsmittel gemahlen werden, das sich von dem in Schritt b) verwendeten nicht-wässrigen Lösungsmittel unterscheidet.

10. Verfahren nach einem der Ansprüche 1 bis 9, wobei die Dauer von Schritt c) im Bereich von 30 Minuten bis 48 Stunden liegt.

11. Verfahren nach einem der Ansprüche 1 bis 9, wobei die Temperatur im Autoklaven im Bereich von 25°C bis 300°C liegt.

12. Verfahren nach einem der Ansprüche 1 bis 11, wobei das photolumineszente Material ein Aluminat, ein Silikat, ein Nitrid, ein Oxynitrid, ein Fluorid oder ein Sulfid ist.

13. Verfahren nach Anspruch 12, wobei das photolumineszente Material hauptsächlich ein Yttrium-Aluminiumoxid oder ein Lutetium-Aluminiumoxid aufweist, das außerdem mindestens eines der folgenden Elemente enthält: Cer, Europium, Chrom, Neodym, Terbium, Dysprosium, Praseodym oder Gadolinium.

14. Verfahren nach einem der Ansprüche 1 bis 13, ferner aufweisend vor Schritt c) einen Schritt des Mischens und Behandelns von Partikeln im Nanometerbereich im Autoklaven in Gegenwart aller oder eines Teils der Vorläufer, die zur Bildung der Partikel im Nanometerbereich verwendet werden.

**15.** Verfahren nach einem der Ansprüche 1 bis 14, ferner aufweisend vor Schritt c) einen Schritt des Mischens der Partikel im Nanometerbereich mit mindestens einer photolumineszenten Substanz (36; 37).

**16.** Verfahren nach Anspruch 15, wobei die photolumineszente Substanz ein Quantenpunkt (37) ist.

**17.** Verfahren nach einem der Ansprüche 1 bis 16, wobei die Partikel im Nanometerbereich (32) Quantenpunkte sind.

**18.** Verfahren nach einem der Ansprüche 1 bis 17, aufweisend das Ausbilden einer stabilen Mischung der Partikel im Nanometerbereich mit einer Resistzusammensetzung.

**19.** Verfahren nach Anspruch 18, wobei der Resist vom Acrylat-Typ ist.

**20.** Verfahren nach Anspruch 18, wobei die Resistzusammensetzung ferner mindestens ein Element aufweist, das aus einem Bindemittel, einem Lösungsmittel, einem Photoinitiator oder diffundierenden Partikeln ausgewählt ist.

**Claims**

**1.** A method of manufacturing nanoparticles of a photoluminescent material, comprising the successive steps of:

a) forming nanometer-range particles (32) of said photoluminescent material;
b) forming a dispersion containing the particles in a non-aqueous solvent, the dispersion further containing at least one surface agent;
c) placing the dispersion in an autoclave at a pressure in the range from 2 MPa to 100 MPa; and
d) recovering the particles.

**2.** The method of claim 1, wherein step b) is preceded by a surface treatment of the nanometer-range particles (32) by a silica precursor.

**3.** The method of claim 1 or 2, wherein the surface agent is an organofunctional compound having the following chemical formula:

$$R_nSiX_{4-n}$$

where n is equal to 1, 2, or 3, X designates a hydrolysable group, and R is a non-hydrolysable organic group.

**4.** The method of claim 3, wherein X is an alkoxy group, a halide group, or an amine group.

**5.** The method of claim 1 or 2, wherein the surface agent is a compound having the following chemical formula:

$$R-Y-R'$$

where Y is a hydrocarbon chain possibly comprising at least one atom of oxygen, and R and R' are chemical groups of thiol (-SH), carboxylic acid (-COOH), alcohol (-OH), amine (-NH2), acrylate type or a non-reactive functional groups.

**6.** The method of any of claims 1 to 5, wherein the non-aqueous solvent is an alcohol.

**7.** The method of any of claims 1 to 6, wherein step a) comprising milling particles of said photoluminescent material having an average size greater than 1 $\mu$m to obtain the nanometer-range particles (32).

**8.** The method of claim 7, wherein the particles of said photoluminescent material having an average size greater than 1 um are milled in a wet environment.

**9.** The method of claim 7, wherein the particles of said photoluminescent material having an average size greater than 1 um are milled in a solvent different from the non-aqueous solvent used at step b).

**10.** The method of any of claims 1 to 9, wherein the duration of step c) is in the range from 30 minutes to 48 hours.

11. The method of any of claims 1 to 9, wherein the temperature in the autoclave is in the range from 25°C to 300°C.

12. The method of any of claims 1 to 11, wherein the photoluminescent material is an aluminate, a silicate, a nitride, an oxynitride, a fluoride, or a sulfide.

13. The method of claim 12, wherein the photoluminescent material mainly comprises an yttrium aluminum oxide or a lutetium aluminum oxide further containing at least one of the following elements: cerium, europium, chromium, neodymium, terbium, dysprosium, praseodymium, or gadolinium.

14. The method of any of claims 1 to 13, further comprising, before step c), a step of mixing and treating in the autoclave nanometer-range particles in the presence of all or part of the precursors used to form the nanometer-range particles.

15. The method of any of claims 1 to 14, further comprising, before step c), a step of mixing the nanometer-range particles with at least one photoluminescent substance (36; 37).

16. The method of claim 15, wherein the photoluminescent substance is a quantum dot (37).

17. The method of any of claims 1 to 16, wherein the nanometer-range particles (32) are quantum dots.

18. The method of any of claims 1 to 17, comprising forming a stable mixture of the nanometer-range particles with a resist composition.

19. The method of claim 18, wherein the resist is of acrylate type.

20. The method of claim 18, wherein the resist composition further comprises at least one element chosen among a binder, a solvent, a photoinitiator or diffusing particles.

```
┌─────────────────────┐
│   Fabrication de    │────10
│   nanoparticules    │
└─────────────────────┘
          │
          ▼
┌─────────────────────┐
│ Mise en dispersion des │
│   nanoparticules dans un │────12
│   solvant non aqueux +   │
│    agent de surface      │
└─────────────────────┘
          │
          ▼
┌─────────────────────┐
│  Transfert dans un  │────14
│      autoclave      │
│     + chauffage     │
└─────────────────────┘
          │
          ▼
┌─────────────────────┐
│  Préparation du     │────16
│   produit final     │
└─────────────────────┘
```

**Fig 1**

**Fig 2**

Fig 3

Fig 4

Fig 5

Fig 6

Fig 7

Fabrication de
particules macroscopiques — $10_1$

Broyage à billes — $10_2$

Fig 8

+ Pentaerythritol tetrakis(3-
mercaptopropionate)

Autoclave

Amine ou initiateur
radicalaire

Pentaerythritol
triacrylate

Fig 9

Fig 10

Fig 11

Fig 12

Fig 13

Fig 14

Volume (%)

Taille (nm)

Fig 15

Volume (%)

Taille (nm)

Fig 16

Volume (%)

Taille (nm)

Fig 17

Fig 18

Fig 19

Fig 20

Fig 21

Fig 22

Fig 23

Fig 24

Fig 25

Volume (%)

Fig 26

Volume (%)

Fig 27

PL

C13

C15      C14   λ (nm)

Fig 28

Volume (%)

Fig 29

PL
(UA)

Fig 30

Volume (%)

Fig 31

PL
(UA)

Fig 32

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1656171

- US 8801968 B2

**Littérature non-brevet citée dans la description**

- *Journal of Applied Polymer Science,* 2008, vol. 109, 467-474